(19) Europäisches Patentamt
European Patent Office
Office européen des brevets

(11) EP 1 333 475 B1

(12) **EUROPEAN PATENT SPECIFICATION**

(45) Date of publication and mention of the grant of the patent:
**10.11.2010 Bulletin 2010/45**

(21) Application number: **01984367.1**

(22) Date of filing: **18.07.2001**

(51) Int Cl.:
***H01L 21/316*** *(2006.01)* ***H01L 21/31*** *(2006.01)*
***H01L 29/78*** *(2006.01)* ***H01J 37/32*** *(2006.01)*
***C23C 16/455*** *(2006.01)* ***C23C 16/458*** *(2006.01)*
***C23C 16/48*** *(2006.01)* ***C23C 16/50*** *(2006.01)*
***C23C 16/452*** *(2006.01)*

(86) International application number:
**PCT/JP2001/006235**

(87) International publication number:
**WO 2002/009166 (31.01.2002 Gazette 2002/05)**

(54) **METHOD FOR FORMING AN INSULATION FILM AND SUBSTRATE PROCESSING APPARATUS THEREFORE**

VERFAHREN ZUR HERSTELLUNG EINES ISOLIERFILMS UND SUBSTRATVERABEITUNGSVORRICHTUNG DAFÜR

PROCEDE DE FABRICATION DE FILM ISOLANT ET APPAREIL DE TRAITEMENT DE SUBSTRAT CORRESPONDANT

(84) Designated Contracting States:
**BE DE FR IT**

(30) Priority: **21.07.2000 JP 2000221172**
**25.01.2001 JP 2001017620**

(43) Date of publication of application:
**06.08.2003 Bulletin 2003/32**

(73) Proprietor: **TOKYO ELECTRON LIMITED**
**Tokyo 107-8481 (JP)**

(72) Inventors:
- **AOYAMA, Shintaro**
**Nirasaki-Shi,**
**Yamanashi 407-0192 (JP)**
- **SHINRIKI, Hiroshi**
**Nirasaki-Shi,**
**Yamanashi 407-0192 (JP)**
- **IGETA, Masanobu**
**Nirasaki-Shi,**
**Yamanashi 407-0192 (JP)**

(74) Representative: **Liesegang, Eva**
**Forrester & Boehmert**
**Pettenkoferstrasse 20-22**
**80336 München (DE)**

(56) References cited:
**EP-A- 0 299 246** **EP-A- 0 661 385**
**JP-A- 2 308 536** **JP-A- 4 274 317**
**JP-A- 5 013 756** **JP-A- 7 029 827**
**JP-A- 11 150 111** **US-A- 4 919 077**
**US-A- 5 585 148** **US-A- 6 028 393**

- **PATENT ABSTRACTS OF JAPAN vol. 1999, no. 11, 30 September 1999 (1999-09-30) -& JP 11 150111 A (SONY CORP), 2 June 1999 (1999-06-02)**
- **PATENT ABSTRACTS OF JAPAN vol. 011, no. 206 (C-433), 3 July 1987 (1987-07-03) -& JP 62 027573 A (YASUO TARUI; others: 02), 5 February 1987 (1987-02-05)**
- **ZHANG JUN-YING ET AL: "Low temperature photo-oxidation of silicon using a xenon excimer lamp" APPLIED PHYSICS LETTERS, AMERICAN INSTITUTE OF PHYSICS. NEW YORK, US, vol. 71, no. 20, 17 November 1997 (1997-11-17), pages 2964-2966, XP012019097 ISSN: 0003-6951**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 333 475 B1

## Description

### TECHNICAL FIELD

The present invention relates to semiconductor devices, and more particularly to the fabrication process of an ultrafine high-speed semiconductor device having a high-K dielectric film.

With progress in the art of device miniaturization, use of gate length of 0.1 μm or less is becoming possible in modem ultrahigh speed high-speed semiconductor devices. Generally, the operational speed of a semiconductor device is improved with device miniaturization, while in such highly miniaturized semiconductor devices, there is a need of reducing the thickness of the gate insulation film according to scaling low with the device miniaturization, and hence with the reduction of the gate length.

### BACKGROUND ART

In the case the gate length has been reduced to 0.1 μm or less, on the other hand, it is necessary to set the thickness of the gate insulation film to 1 - 2nm when $SiO_2$ is used for the gate insulation film. In such extremely thin gate insulation films, on the other hand, there occurs an increase of tunneling current, and the problem of increase of gate leakage current becomes inevitable.

Under such a situation, there has been a proposal of using a so-called high-K dielectric film having a specific dielectric constant much larger than that of an $SiO_2$ film and thus capable of realizing a small film thickness in terms of the thickness converted to that of an $SiO_2$ film while maintaining a large actual film thickness, such as the film of $Ta_2O_5$, $Al_2O_3$, $ZrO_2$, $HfO_2$, $ZrSiO_4$ or $HfSiO_4$, for the gate insulation film. By using such a high-K dielectric film, it becomes possible to use a gate insulation film having a physical thickness of about 10nm also in an ultrahigh speed semiconductor device having a gate length of 0.1 μm or less, and the gate leakage current formed by the tunneling effect is successfully suppressed.

For Example, it is known that a $Ta_2O_5$ film substrate can be formed by a CVD process by using $Ta(OC_2H_5)_5$ and $O_2$ as gaseous sources. Typically, the CVD process is conducted under a reduced to pressure environment at the temperature of about 480 °C or more. The $Ta_2O_5$ film thus formed is then annealed in oxygen ambient, and as a result, the oxygen vacancies in the film are eliminated. Further, the film undergoes crystallization. The $Ta_2O_5$ film thus crystallized shows a large specific dielectric constant.

In a semiconductor device that uses such a high-K dielectric film for the gate insulation film, it is preferable to form the high-K dielectric film directly on a Si substrate for reducing the $SiO_2$ equivalent thickness of the insulation film. However, in the case the high-K dielectric film is formed directly on the Si substrate, the metal elements in the high-K dielectric film tend to cause diffusion into the Si substrate, and there arises the problem of carrier scattering in the channel region.

From the viewpoint of improving carrier mobility in the channel region, it is preferable to interpose an extremely thin base oxide film having a thickness of 1nm or less, preferably 0.8 nm or less, between the high-K dielectric gate oxide film and the Si substrate. It should be noted that this base oxide film has to be extremely thin. Otherwise, the effect of using the high-K dielectric film for the gate insulation film would be canceled out. Further, such an extremely thin base oxide film has to cover the surface of the Si substrate uniformly, without forming defects such as interface states.

Conventionally, it has been generally practiced to form a thin gate oxide film by a rapid thermal oxidation (RTO) process of a Si substrate. When to form a thermal oxide film with the desired thickness of 1 nm or less, on the other hand, it is necessary to reduce the process temperature used at the time of the film formation. However, a thermal oxide film thus formed at such a low temperature tends to contain interface states and is deemed inappropriate for the base oxide film of a high-K dielectric gate oxide film.

In the case of a base oxide film, in particular, it has been discovered by the inventor of the present invention that minute fluctuation of thickness of the base oxide film provides a profound effect on the incubation time when a high-K dielectric gate insulation film is formed on such a base oxide film. This means that non-uniformity, or variation of film thickness in the base oxide film may cause serious effect on the high-K dielectric gate insulation film formed thereon and the device characteristic of the semiconductor device may be deteriorated. In view of the situation noted above, it will be understood that the base oxide film formed underneath the high-K dielectric gate insulation film is required not only having a small thickness but also a uniform thickness.

United States Patent US 6 028 393 discloses a method and apparatus for forming an insulation film on a substrate, in which a plasma of excited species is created by both microwave and electron beam energy at a first source, and a different plasma from a different source may be created alongside the first plasma to form a single common plasma plume. The quality of the insulation film can be optimized by varying the distance between the plasma and the substrate, or the orifice size of the plasma sources.

Japanese Patent Application JP11-150111 A describes a method and apparatus for forming a thin film in a plasma processing apparatus by introducing a processing gas through a single gas introducing pipe. Active radicals are formed on the surface of a rotating substrate by means of irradiating the surface with ultraviolet radiation from an ultraviolet source. The thickness of the film can be controlled by adjusting the processing gas partial pressure and the temperature of the processing, and by providing an ultraviolet lamp with high precision. European Patent Application EP 0 661 385 A1 discloses a method and apparatus for forming a thin film on a substrate by electrolytically dissociating the processing gas at the surface of the substrate by means of irradiation with ultraviolet rays.

DISCLOSURE OF THE INVENTION

Accordingly, it is a general object of the present invention to provide a novel and useful substrate processing method wherein the foregoing problems are eliminated.

Another and more specific object of the present invention is to provide a substrate processing method and a substrate processing apparatus capable of forming an insulation film of a predetermined thickness between a substrate and a high-K dielectric gate insulation film with a uniform thickness without forming defects such as interface states.

Another object of the present invention is to provide a method of forming an insulation film on the substrate, according to claim 1.

Another object of the present invention is to provide a substrate processing of apparatus for forming an insulation film on a substrate, according to claim 6.

The present invention enables formation of an insulation film of uniform film quality in a substrate processing of apparatus using remote plasma by optimizing of the state of the remote plasma source.

Other features and advantages of the present invention will become apparent from the detailed explanation of preferred embodiments of the invention provided hereinafter with reference to the drawings.

BRIEF DESCRIPTION OF THE DRAWINGS

FIG.1 is a diagram showing the construction of a semiconductor device having a high-K dielectric gate insulation film;
FIG.2 is a diagram explaining the principle of the present invention;
FIG.3 is a diagram showing the construction of a substrate processing apparatus according to a first example helpful for understanding the present invention;
FIGS.4A - 4C are diagrams showing the distribution of film thickness of an oxide film formed by the substrate processing apparatus of FIG.3;
FIG.5 is a diagram showing the relationship between the process time and film thickness for an oxide film formed by the substrate processing apparatus of FIG.3;
FIGS.6A - 6E are other diagrams showing the film thickness distribution of the oxide film formed by the substrate processing apparatus of FIG.3;
FIGS.7A - 7E are further diagrams showing the film thickness distribution of the oxide film formed by the substrate processing apparatus of FIG.3;
FIGS.8A and 8B are diagrams showing the film thickness distribution of an oxide film according to a comparative example;
FIG.9 is a flow chart showing the procedure for determining the optimum scanning region according to a first example helpful for understanding the present invention;
FIG.10 is a flow chart showing the procedure of determining the optimum drive energy of the optical source according to the first example helpful for understanding the present invention;
FIG.11 is a diagram showing the construction of a cluster type substrate processing apparatus according to a second example helpful for understanding the present invention;
FIG.12 is a diagram showing the construction of a cluster type substrate processing apparatus according to a third example helpful for understanding the present invention;
FIG.13 is a diagram showing the construction of a semiconductor device fabricated by the substrate processing apparatus of FIG.12;
FIG.14 is a diagram showing a modification of the substrate processing apparatus of FIG. 3;
FIGS.15A and 15B are diagrams showing a further modification of the substrate processing apparatus of FIG.3;
FIG. 16 is a diagram showing further modification of the substrate processing apparatus of FIG.3;
FIG. 17 is a diagram showing the relationship between the oxide film thickness formed by ultraviolet activated oxidation processing and the ultraviolet radiation dose according to a fourth example helpful for understanding the present invention;

FIGS.18A - 18F are diagrams showing the oxide film thickness distribution on the substrate for each of the specimens obtained in the experiment of FIG.17;

FIG.19 is a diagram explaining the mechanism of formation of stepped pattern shown in FIG.17;

FIGS.20A and 20B are diagrams showing the distribution of ultraviolet radiation intensity on the substrate for the case the substrate processing apparatus of FIG. 16 is applied for a wafer of 300 mm diameter;

FIGS.21A and 21B are diagrams showing a substrate processing apparatus and intensity distribution of ultraviolet radiation according to a fifth example helpful for understanding the present invention;

FIG.22 is a diagram showing the construction of substrate processing apparatus according to a sixth example helpful for understanding the present invention;

FIG.23 is a diagram showing the intensity distribution of ultraviolet radiation in the substrate processing apparatus of FIG.22;

FIG.24 is a diagram showing the construction of a substrate processing apparatus according to a seventh example helpful for understanding the present invention;

FIG.25 is a diagram showing the intensity distribution of the ultraviolet radiation in the substrate processing apparatus of FIG.24;

FIG.26 is a diagram showing the construction of one substrate processing apparatus according to an eighth example helpful for understanding the present invention;

FIG.27 is an oblique view diagram showing a part of the substrate processing apparatus of FIG.26 in an enlarged scale;

FIG.28 is a diagram showing that intensity distribution of ultraviolet radiation in the substrate processing of apparatus of FIG. 26;

FIGS.29A and 29B are diagrams showing the construction of a conventional substrate processing apparatus that uses a remote plasma source and the problem thereof;

FIG.30 is a diagram showing the construction of a conventional remote plasma source;

FIGS.31A and 31B are diagrams showing the construction of a substrate processing apparatus according to embodiments of the present invention;

FIGS.32A and 32B are diagrams showing an example of substrate processing conducted by the substrate processing apparatus of FIGS.31A and 31B;

FIG.33 is a diagram showing the procedure of optimization of the substrate processing apparatus of FIGS.31A and 31B;

FIG.34 is a diagram showing the mechanism provided for conducting the optimization procedure of FIG.33;

FIG.35 is another diagram showing the optimization procedure of the substrate processing apparatus of FIGS.31A and 31B;

FIG.36 is a diagram showing the construction for conducting the optimization of FIG.35;

FIGS.37A and 37B are diagrams showing a modification of an embodiment of the present invention;

FIG.38 is a diagram showing a modification of an embodiment helpful for understanding the invention.

FIG.39 is a diagram showing the construction of a substrate processing apparatus according to a 9th example helpful for understanding the present invention;

FIG.40 is a diagram explaining the principle of the substrate processing apparatus of FIG.39; FIGS.41A and 41B are other diagrams explaining the principle of the substrate processing apparatus of FIG.39;

FIGS.42A and 42B are other diagrams explaining the principle of the substrate processing apparatus of FIG.39;

FIGS.43A and 43B are other diagrams explaining the principle of the substrate processing apparatus of FIG.39;

FIGS.44A and 44B are diagrams showing an example of film formation by the substrate processing apparatus of FIG.39;

FIGS.45A and 45B are diagrams showing the construction of a substrate processing of apparatus according to a 10th example helpful for understanding the present invention; FIG.46 is a diagram showing a modification of the substrate processing apparatus of FIGS.45A, B;

FIG.47 is a diagram showing the construction of a substrate processing apparatus according to an 11th example helpful for understanding the present invention;

FIG.48 is a diagram showing the construction of a cluster type substrate processing system that uses the substrate processing apparatus of FIG.47;

FIG.49 is a diagram showing the construction of a semiconductor device formed by the substrate processing apparatus of FIG.47;

FIG.50 is a flow chart showing the process flow of forming the semiconductor device of FIG.49 by using the cluster type substrate processing system of FIG.48; and

FIG.51 is a diagram showing the control timing of the substrate processing apparatus corresponding to the process flow of FIG.50.

BEST MODE OF IMPLEMENTING THE INVENTION

[RPINCIPLE]

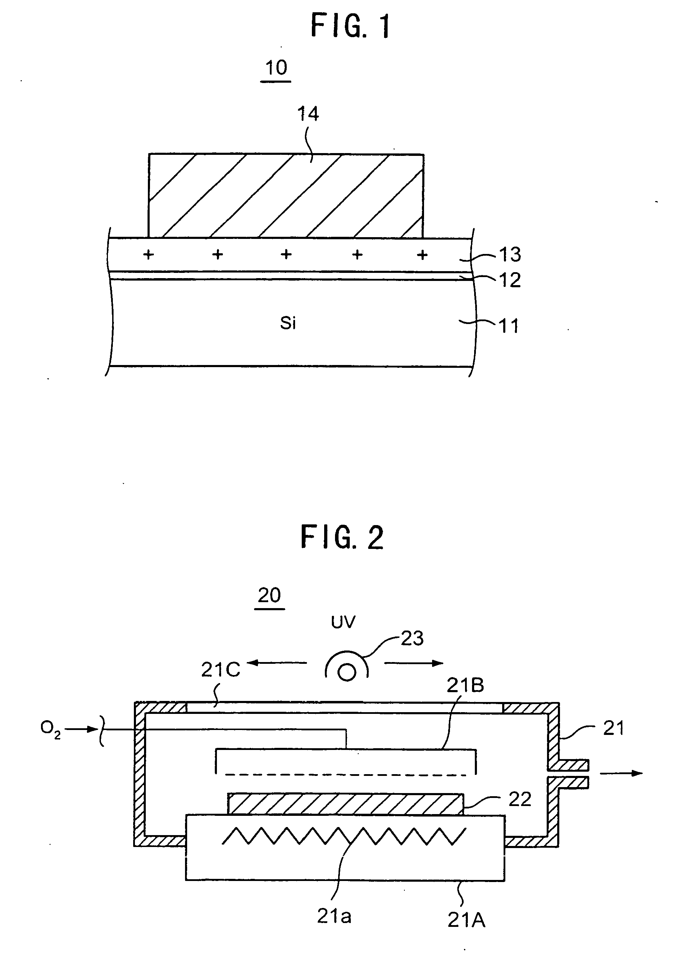

FIG.1 shows the construction of a high-speed semiconductor device 10 having a high-K dielectric gate insulation film, while FIG.2 shows the principle of the present invention used for fabricating the semiconductor device of FIG.1.
Referring to FIG.1, the semiconductor device 10 is constructed on a Si substrate 11 carrying thereon a high-K dielectric gate insulation film 17 such as $Ta_2O_5$, $Al_2O_3$, $ZrO_2$, $HfO_2$, $ZrSiO_4$, $HfSiO_4$, and the like, via an intervening thin base oxide film 12, and a gate electrode 14 is formed on the foregoing high-K dielectric gate insulation film 13.
As explained before, it is preferable that the base oxide is formed as thin as possible in such a high speed semiconductor device 10, and thus, the base oxide film 12 is typically formed with a thickness of 1nm or less, preferably 0.8nm or less. On the other hand, it is required that the base oxide film 12 covers the surface of the Si substrate uniformly with a uniform thickness.
FIG.2 shows the schematic construction of a substrate processing apparatus 20 used for forming the base oxide film 12 on the Si substrate 11 with a uniform thickness.
Referring to FIG.2, the substrate processing apparatus includes a processing vessel 21 for holding a substrate 22 to be processed under a reduced pressure environment, wherein the substrate 22 is held on a stage 21 A provided with a heater 21. Further, there is provided a shower head 21B in the processing vessel 21 so as to face the substrate 22 held on the stage 21, and an oxidizing gas such as $O_2$, $O_3$, $N_2O$, NO or a mixture thereof, is applied to the showerhead 21B.
The showerhead 21B is formed of a material transparent to ultraviolet radiation such as quartz, and there is provided a window 21C of a material such as quartz transparent to the ultraviolet radiation on the processing vessel 21, such that the window 21C exposes the substrate 22 on the stage 21A. Further, there is provided an ultraviolet optical source 23 outside the window 21C so as to be moveable along the surface of the window 21C.
Thus, a Si substrate is introduced into the processing vessel 21 as the substrate 22, and an oxidizing gas such as $O_2$ is introduced after evacuating the interior of the processing of vessel 21. Further, by driving the ultraviolet source 23, active radicals such O* are formed in the oxidizing gas. It should be noted that such the radicals thus activated by the ultraviolet radiation oxidize the exposed surface of the Si substrate 22, and as a result, there is formed an extremely thin oxide film having a thickness of about 0.5 - 0.8nm on the surface of the Si substrate 22.
In an example helpful for understanding the present invention, it is possible to form the oxide film with uniform thickness by moving the ultraviolet source 23 along the optical window 21C according to a predetermined program. More specifically, it is possible to compensate for any non-uniformity of film thickness by controlling the position of the ultraviolet source 23 to an optimum substrate region or by controlling the drive energy of the ultraviolet source 23 to an optimum energy level discovered experimentally in advance, even in such a case the oxide film tends to show a reduced thickness in a particular region of the substrate 22 due to the character of the apparatus. Thus, it becomes possible to suppress the problem of variation of film thickness of a high-K dielectric gate insulation film in the case a high-K dielectric gate insulation film is deposited on such oxide film, and a semiconductor device having a stable characteristic is obtained.
Because the oxide film is thus formed by the ultraviolet activate oxidation process, the oxide film contains little interface states as is reported by Zhang, et al. (Zhang, J-Y, et al., Appl. Phys. Lett. 71(20), 17 November 1997, pp. 2964-2966), and the oxide film is suitable for the base oxide film 12 provided underneath the high-K dielectric gate insulation film shown in FIG.1.

[FIRST EXAMPLE HELPFUL FOR UNDERSTANDING THE PRESENT INVENTION]

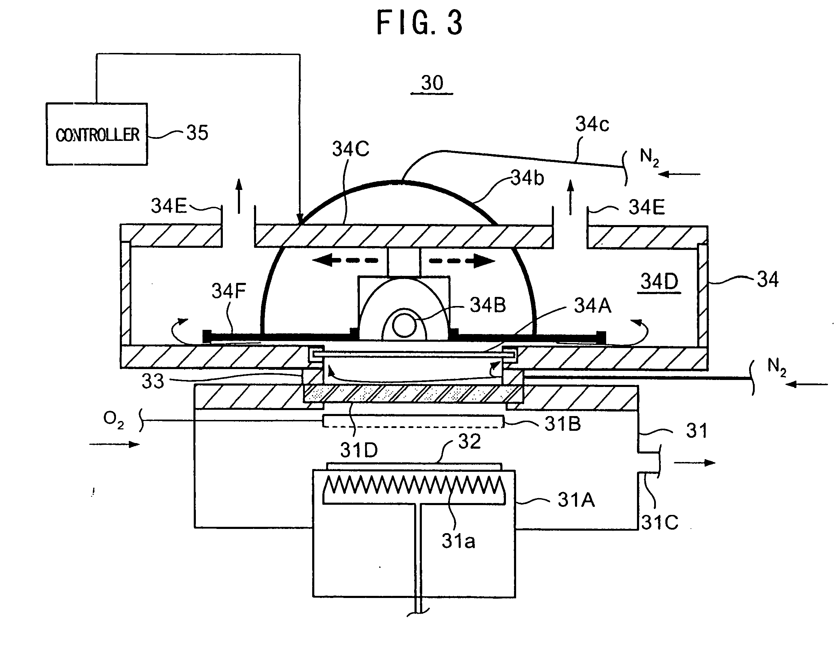

FIG.3 shows the construction of the substrate processing apparatus 30 according to a first example helpful for understanding the present invention.
Referring to FIG.3, the substrate processing apparatus 13 includes a processing vessel 31 having a stage 31A holding substrate 32 to be processed thereon, and there is provided a showerhead 31B of a material such as quartz transparent to ultraviolet radiation. The showerhead 31B is provided so as to face the substrate on the stage 31A. Further, the processing vessel 31B is evacuated through an evacuation port 31C, and an oxidizing gas such as $O_2$ is supplied to the foregoing showerhead 31B from an external gas source.
It should be noted that the processing vessel 31 is formed with an optical window 31B of a material transparent to ultraviolet radiation such as quartz above the showerhead 31B such that the optical window 31B exposes the showerhead 31B and the substrate 32 underneath the showerhead 31B. Further, the stage 31 A is provided with a heater 31a for heating the substrate 32.
Further, there is provided an ultraviolet exposure apparatus 34 above the processing vessel 31 via an intervening connection part 33 provided in correspondence to the optical window 31D.
The ultraviolet exposure apparatus 34 includes a quartz optical window 34A corresponding to the optical window 31D and an ultraviolet source 34B radiating ultraviolet radiation upon the substrate 32 via the optical window 31D, wherein the ultraviolet source 34B is held by a robot 34C movably in a direction parallel to the optical window 34A as is represented in FIG.3 by an arrow. In the illustrated example, the ultraviolet source 34B is formed of a linear optical source extending in the direction generally perpendicular to the moving direction of the ultraviolet source 34B. For such a linear optical source, it is possible to use an excimer lamp having a wavelength of 172 nm.

In the construction of FIG.3, it should be noted that an inert gas such as $N_2$ is supplied to the connection part 33 from an external gas source (not shown) via a line 33A for avoiding the problem of absorption of the ultraviolet radiation by the oxygen in the air before the ultraviolet radiation formed by the ultraviolet radiation source 34B is introduced into the processing vessel 31 through the optical window 31D. The foregoing inert gas flows into the space 34D inside the ultraviolet exposure apparatus 34 through a gap formed in the mounting part of the optical window 34A of the ultraviolet exposure apparatus 34.

Further, in order to suppress the incoming flow of oxygen in the air into the region right underneath the ultraviolet source 34B with the driving of the ultraviolet source, there is provided a shielding plate 34F at both lateral sides of the ultraviolet source 34B, and an inert gas such as $N_2$ is supplied into a narrow region, which is formed between the optical window 34A opposing the ultraviolet source 34B and the shielding plate 34F with a height of about 1 mm or so, via a line 34b. This region is also supplied with the inert gas from the line 33A, and as a result, oxygen absorbing the ultraviolet radiation is effectively purged from this region.

The inert gas passed through the region underneath the shielding plate 34F is caused to flow into the foregoing space 34D and is then discharged to the outside of the ultraviolet exposure apparatus 34 through an evacuation port 34B formed in the ultraviolet exposure apparatus 34.

In the substrate processing apparatus of FIG.3, it is possible to control the movement and scanning of the ultraviolet source 34B by the robot 34C of the ultraviolet exposure apparatus 34, and as a result, it becomes possible to control the film thickness distribution at the time of formation of the oxide film on the surface of the substrate 32 by the ultraviolet-activated oxidation processing, by controlling the a ultraviolet radiation dose. Further, it should be noted that the controller 35 controls the driving of the ultraviolet source 34B.

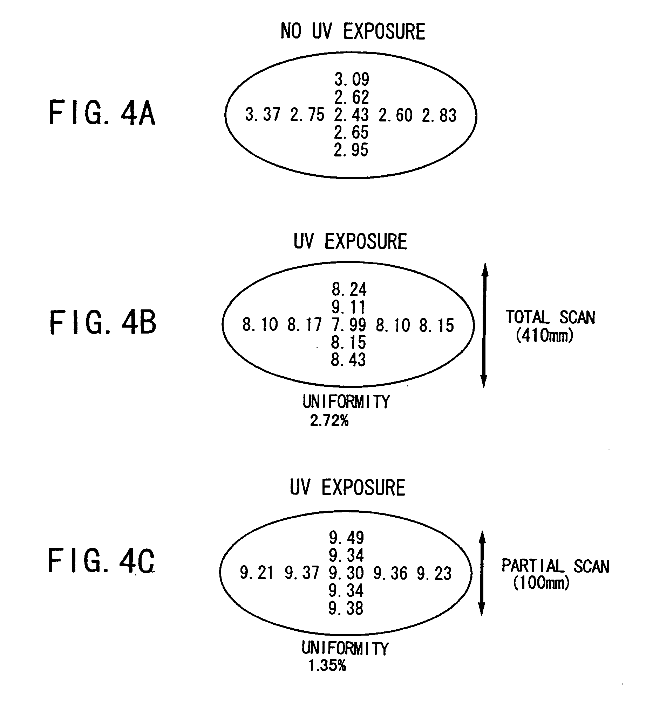

FIGS.4A - 4C show the thickness distribution of the $SiO_2$ film for the case the $SiO_2$ film is formed on an Si substrate by using the substrate processing apparatus 30 of FIG.3 under various conditions, wherein FIGS.4A - 4C show the film thickness in terms of Angstroms. In FIGS.4A - 4C, it should be noted that an 8-inch Si substrate is used for the substrate 32 in the state the native oxide film is removed by a surface pre-processing step, which will be explained later. In each of FIGS.4A - 4C, the internal pressure of the processing vessel 31 is set to 0.7kPa (5 Torr) and the substrate temperature is set to 300°C.

It should be noted that the illustrated result is for the case $O_2$ is supplied into the processing vessel 31 with the flow rate of 1 SLM for 5 minutes, wherein FIG.4A shows the case in which no ultraviolet irradiation has been made, while FIGS.4B and 4C show the cases in which the ultraviolet radiation applied with a dose of 30mW/cm$^2$ when measured in the part right underneath the optical source. It should be noted that FIG.4B shows the case in which the ultraviolet optical source 34B has scanned the range of 410 mm, so that the entire surface of the substrate 32 is uniformity exposed.

Referring to FIG.4A, it will be noted that the $SiO_2$ film formed on the Si substrate surface has the thickness of 0.2 - 0.3nm in the case no ultraviolet radiation has been applied. This means that no substantial film formation has been caused in this case. In the case of FIG.4B, on the other hand, it can be seen that an $SiO_2$ film of about 0.8nm thickness is formed on the surface of the Si substrate. Further, in the case of FIG.4B, it can be seen that the thickness of the $SiO_2$ film is reduced at the central part of the 8-inch Si substrate 32 even in the case the ultraviolet source 34B has scanned uniformly over the range of 400mm. As a result, it can be seen that the variance of thickness of the $SiO_2$ film formed on the Si substrate takes a relatively large value of 2.72%. It is believed that this reflects the characteristic pertinent to the particular substrate processing apparatus 30 used for the experiment.

FIG.4C, on the other hand, shows the thickness distribution of the $SiO_2$ film for the case the scanning of the ultraviolet source 34B is made in a limited range of 100nm at the central part of the Si substrate 32.

Referring to FIG.4C, it can be seen that the thickness of the $SiO_2$ film thus formed falls in the range of 0.92 - 0.93nm and that the variation of the film thickness has been reduced to 1.35%.

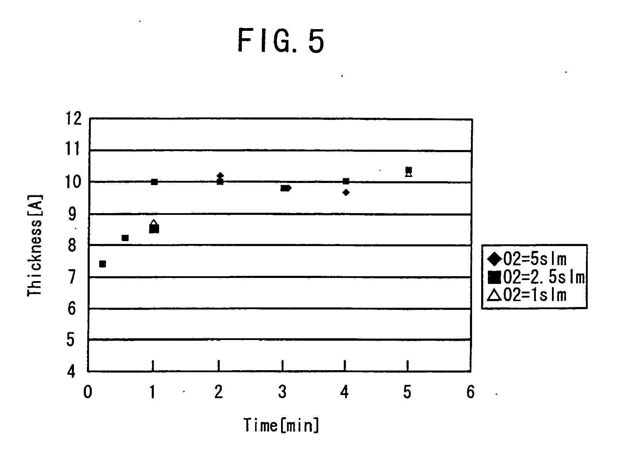

FIG.5 shows the relationship between the ultraviolet exposure time and the thickness of the $SiO_2$ film for the case the flow rate of 02 introduced into the processing vessel 31 is changed variously in the experiment of FIGS.4A - 4C.

As can be seen from FIG.5, the thickness of the $SiO_2$ film thus formed is substantially irrelevant to the $O_2$ flow rate and there appears saturation at about 1nm after the duration of 1 minute. On the other hand, in the case the exposure time is less than 1 minute, the film thickness increases with the exposure time. Thus, FIG.5 shows that a very short time is sufficient for the formation of the $SiO_2$ film used for the base oxide film on the surface of the Si substrate when the substrate processing apparatus 30 of FIG.3 is used.

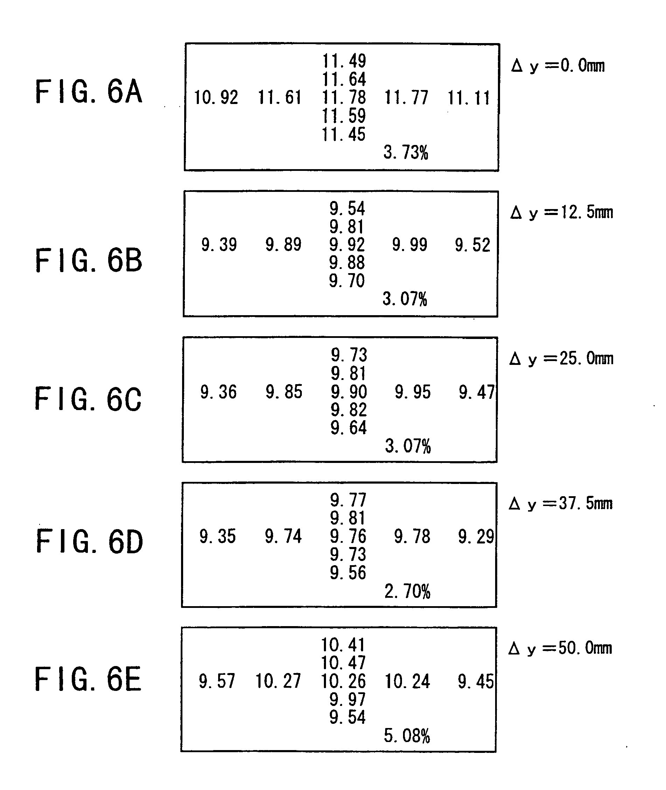

FIGS.6A - 6E show the thickness distribution of the $SiO_2$ film obtained for the case the ultraviolet source 34B has scanned the area of 100mm in the substrate processing apparatus of FIG.3 in the state an $O_2$ gas is supplied with a flow rate of 1 SLM and the processing has been made under the internal pressure of the processing vessel of about 0.7kPa (5 Torr) at the substrate temperature of 450°C. For the sake of simplicity, the Si substrate is represented by a rectangle in the drawings.

It should be noted that FIG.6A shows the case in which the scanning has been made over the range of +/- 50mm about the center of the substrate, wherein it will be noted that there is a tendency of the $SiO_2$ film increasing the thickness thereof in the upward direction along the y-axis from the center of the substrate and also in the rightward direction along the x-axis.
In this case, the variation of the thickness of the $SiO_2$ film becomes 3.73%.

On the other hand, FIG.6B shows the thickness distribution of the $SiO_2$ film represented in terms of Angstroms for the case the origin of scanning is displaced by 12.5 mm on the y-axis in the downward directions. As can be seen from FIG.6B, the variation of thickness of the $SiO_2$ film is reduced to 3.07%.

Further, FIG.6C shows the thickness distribution of the $SiO_2$ film represented in terms of Angstroms for the case the origin of scanning has been displaced by 25.0mm in the downward direction on the y-axis. As can be seen from FIG.6C, the variation of thickness of the $SiO_2$ film becomes 3.07%, which is identical with the case of FIG.6B.

On the contrary, FIG.6D shows the thickness distribution of the $SiO_2$ film represented also in terms of Angstroms for the case the origin of scanning is displaced by 37.5mm on the y-axis in the downward direction from the center of the substrate. As can be seen from FIG.6D, the variation of thickness of the $SiO_2$ film is reduced to 2.70%.

Further, as represented in FIG.6E, the variation of thickness of the $SiO_2$ film increases to 5.08% in the case the origin of scanning is offset on the y-axis in the downward direction from the center of the substrate by the distance of 50.0mm.

From these results, it is concluded that the variation of thickness of the $SiO_2$ film formed on the substrate 32 can be minimized in the substrate processing apparatus 30 of FIG.3 by optimizing the region of scanning of the ultraviolet source 34B with regard to the substrate.

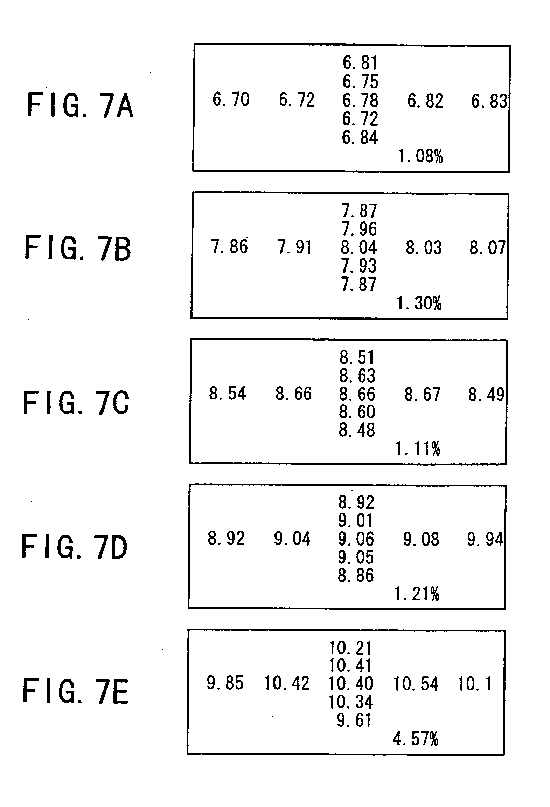

FIGS.7A - 7B show the thickness distribution of the $SiO_2$ film represented in terms of Angstroms for the case the scanning range of the ultraviolet source 34B is set to 100mm in the substrate processing apparatus 30 of FIG.3 and the origin of scanning is offset by 37.5 mm on the y-axis in downward direction from the center of the substrate 32. Here, the $SiO_2$ film has been formed by setting the radiation dose to any of: 3mW/cm$^2$, 6mW/cm$^2$, 12mW/cm$^2$, 18mW/cm$^2$, and 24mW/cm$^2$.

Referring to FIGS.7A - 7E, it can be seen that the variation of the film thickness becomes minimum in the case the radiation dose is set to 3mW/cm$^2$ as represented in FIG.7A and that the variation increases with increasing radiation dose.

The result FIGS.7A - 7E indicates that it is also possible to minimize the variation of film thickness of the $SiO_2$ film by optimizing the radiation dose of the ultraviolet source 34B in the substrate processing apparatus 30 of FIG. 3.

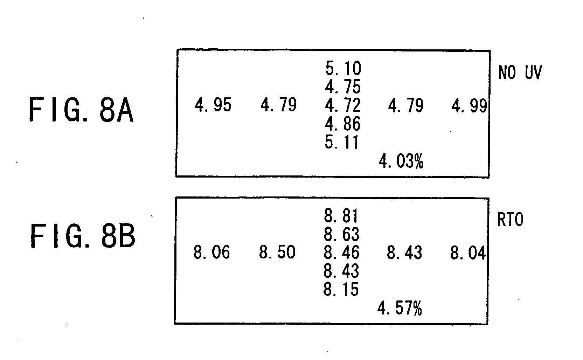

FIGS.8A and 8B show comparative examples wherein FIG.8A represents the case of forming an $SiO_2$ film under the identical condition of FIGS.7A - 7E but without conducting ultraviolet irradiation, while FIG.8B shows the case of forming an $SiO_2$ film by a conventional rapid thermal oxidation processing. In any of these cases, it can be seen that the variation of the film thickness exceeds 4%.

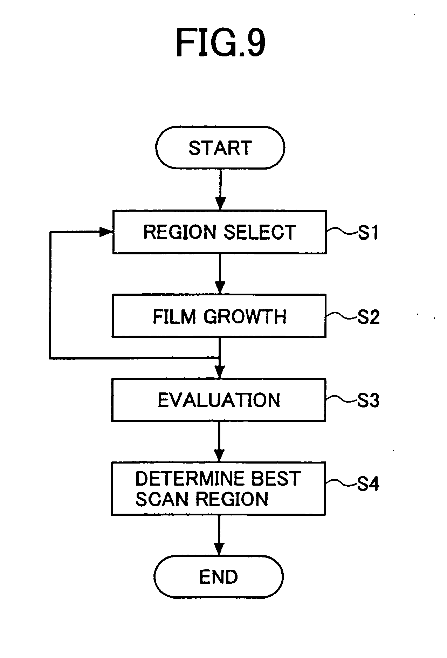

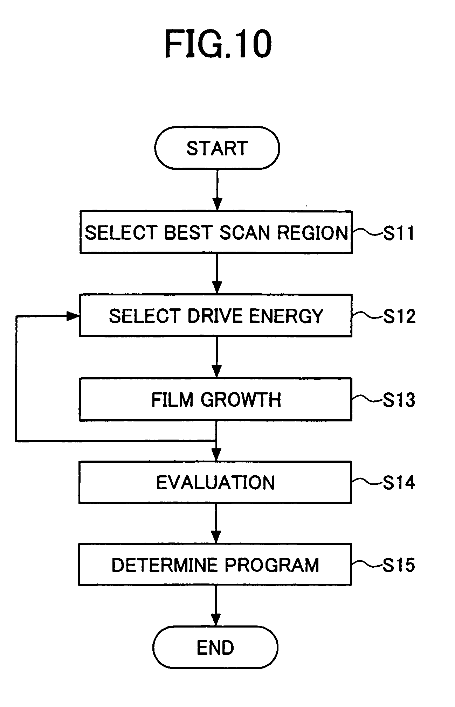

FIGS.9 and 10 are flow charts used for seeking for the optimum condition of substrate processing in the substrate processing apparatus 30 of FIG.3 based on the above-mentioned results. Here, it should be noted that FIG.9 is the flow chart for seeking for the optimum scanning region, while FIG.10 is the flow chart seeking for the optimum radiation dose.

Referring to FIG.9, an arbitrary 3 region on the substrate is specified in the first step 1, and in the next step 2, the substrate 32 is introduced into the substrate processing apparatus 30. Thereby, the ultraviolet source 34B is caused to scan over the specified region of the substrate 32, and formation of an $SiO_2$ film is achieved. Further, by repeating the steps 1 and 2 and by displacing the foregoing region on the substrate 32 each time, a number of $SiO_2$ films are formed.

Further, the step 3 is conducted for evaluating the distribution of thickness for the $SiO_2$ films thus obtained in the experiments, and the step 4 is conducted for seeking for the optimum scanning region in which the variation of film thickness becomes minimum.

After the search of FIG.9 for the optimum scanning condition, a search of optimum irradiation condition shown in FIG.10 is conducted.

Referring to FIG.10, the optimum scanning region searched by the procedure of FIG.9 is specified in the step 11, and the driving energy of the ultraviolet source 34B is specified in the next step 12. Further, in the step 13, the substrate 32 is introduced into the substrate processing apparatus 30, and the ultraviolet source 34B is caused to scan over the specified region of the substrate 32 with the drive energy specified by the step 12. With this, an $SiO_2$ film is formed. Further, by repeating of the steps 12 and 13, and by displacing and the driving energy each time, a number of $SiO_2$ films are formed.

Further, in the step 14, the thickness distribution is evaluated for the $SiO_2$ films thus obtained in the experiments, and the optimum driving energy of the ultraviolet source 34B that minimizes the thickness of variation is searched. Further, in the step 15, the program controlling the ultraviolet source 34B of said substrate processing apparatus 30 is determined such that the film formation is conducted under such an optimum driving energy.

The controller 35 controls the robot 34C and the ultraviolet source 34 B according to the program thus determined, and as a result, an extremely thin and uniform $SiO_2$ film is formed on the substrate 34 with a thickness of 0.3 - 1.5 nm, preferably 1nm or less, more preferably 0.8 nm or less.

[SECOND EXAMPLE HELPFUL FOR UNDERSTANDING THE PRESENT INVENTION]

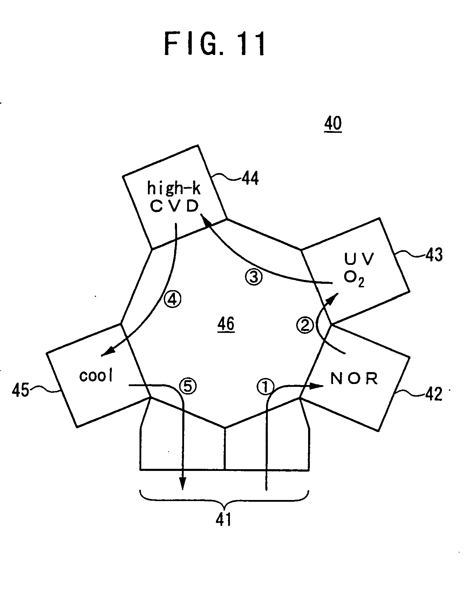

FIG.11 shows the construction of a substrate processing system 40 according to a second example helpful for understanding the present invention in which the substrate processing apparatus 30 of FIG.3 is incorporated.

Referring to FIG.11, the substrate processing system 40 is a cluster type apparatus and includes a load lock chamber 41 used for loading and unloading a substrate, a preprocessing chamber 42 for processing the substrate surface by nitrogen radicals N* and hydrogen radicals H* and an NF3 gas. The preprocessing chamber thereby removes the native oxide film on the substrate surface by converting the same to a volatile film of N-O-Si-H system. Further, the cluster type processing apparatus includes a UV-$O_2$ processing chamber 43 including the substrate processing apparatus 30 of FIG.3, a CVD processing chamber 44 for depositing a high K dielectric film such as $Ta_2O_5$, $Al_2O_3$, $ZrO_2$, $HfO_2$, $ZrSiO_4$, $HfSiO_4$, and the like, and a cooling chamber 45 for cooling the substrate, wherein the chambers 41 through 45 are connected with each other by a vacuum transportation chamber 46, and the vacuum transportation chamber 46 is provided with a transportation arm (not shown).

In operation, the substrate introduced via the load lock chamber 41 is forwarded to the preprocessing chamber 42 along a path (1), and the native oxide film is removed therefrom. The substrate 42 thus removed the native oxide film in the preprocessing chamber 42 is then introduced into the UV-$O_2$ processing chamber 43 along a path (2), and the $SiO_2$ base oxide 12 shown in FIG. 1 is formed with a uniform thickness of 1nm or less, by scanning the optimum region of the substrate with the ultraviolet source 34 B in the substrate processing apparatus 30 of FIG.3.

Further, the substrate thus formed with the $SiO_2$ film in the UV-$O_2$ processing chamber 43 is introduced into the CVD processing chamber 44 along a path (3), and the high-K dielectric gate insulation film 14 shown in FIG.1 is formed on the $SiO_2$ film thus formed.

Further, the substrate is transported from the CVD chamber 44 to the cooling chamber 45 along a path (4) for cooling, and after cooling in the cooling chamber 45, the substrate is returned to the load lock chamber 41 along a path (5) for transportation to the outside.

[THIRD EXAMPLE HELPFUL FOR UNDERSTANDING THE PRESENT INVENTION]

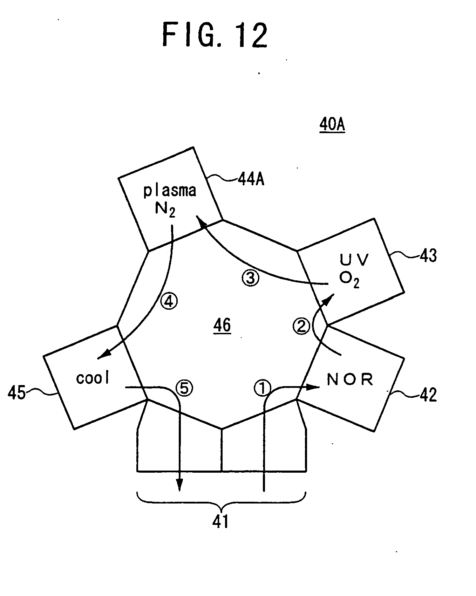

FIG.12 shows the construction of a substrate processing system 40A according to a third example helpful for understanding the present invention.

Referring to FIG.12, the substrate processing system 40A has the construction similar to that of the substrate processing system 40 except that there is provided a plasma nitridation processing chamber 44A in place of the CVD processing chamber 44.

The plasma nitridation processing chamber 44A is supplied with the substrate formed with the $SiO_2$ film in the UV-$O_2$ processing chamber 43 along a path (3), and a SiON film is formed on the surface thereof by plasma nitridation processing.

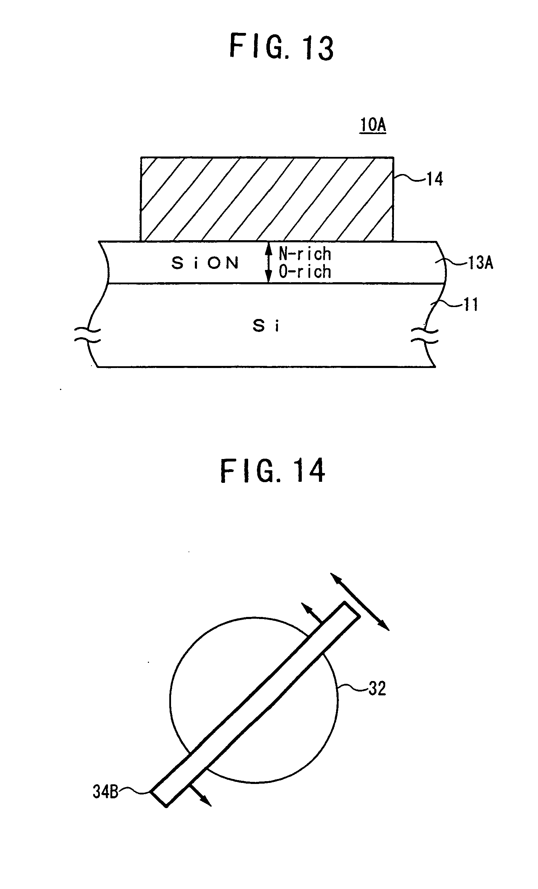

By repeating such process steps between the UV-$O_2$ processing chamber 43 and the plasma nitridation processing chamber 44A, a semiconductor device 10A having a SiON gate insulation film 13A shown in FIG.13 is obtained. In FIG.13, it should be noted that those parts explained previously are designated by the same reference numerals and the description thereof will be omitted.

In the structure 10A of FIG.13, the SiON gate insulation film 13A is formed with the thickness of 1.5 - 2.5nm, wherein it is possible to form the SiON gate insulation film 13A with a compositional gradient such that the bottom part thereof is enriched with O and the top part thereof is enriched with N.

[MODIFICATION]

In the substrate processing apparatus 30 of FIG.3, it should be noted that the movement of the linear ultraviolet source 34B is not limited to the back and forth movement in the direction represented in FIG.3 by arrows but it is also possible to rotate the substrate 32 and combine the back-and-forth movement therewith as represented in FIG.14. Further, such a rotation of the optical source 34B with respect to the substrate 32 may be at achieved by rotating the optical source 34B itself or by a rotating of the substrate 32.

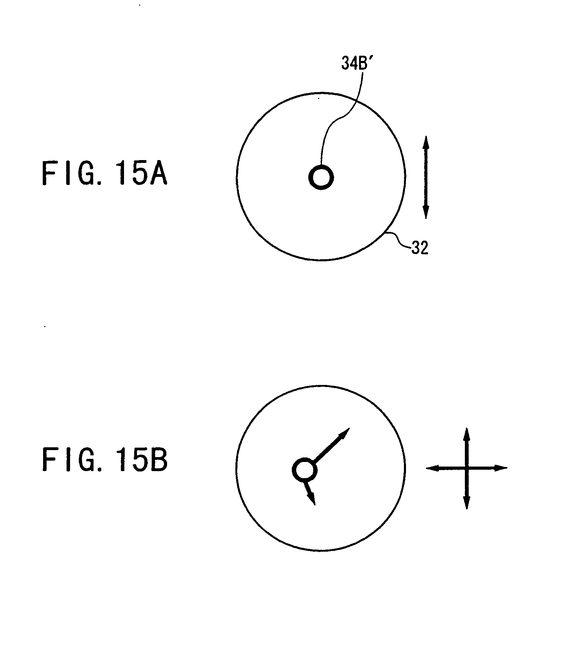

Further, in the substrate processing apparatus 30 of FIG.3, it is also possible to use a point-like ultraviolet source 34B' as represented in FIG.15A in place of the linear ultraviolet optical source 34B, and move such a point-like ultraviolet source 34B' in the vertical and horizontal directions on the substrate 32 as represented in FIG.15B.

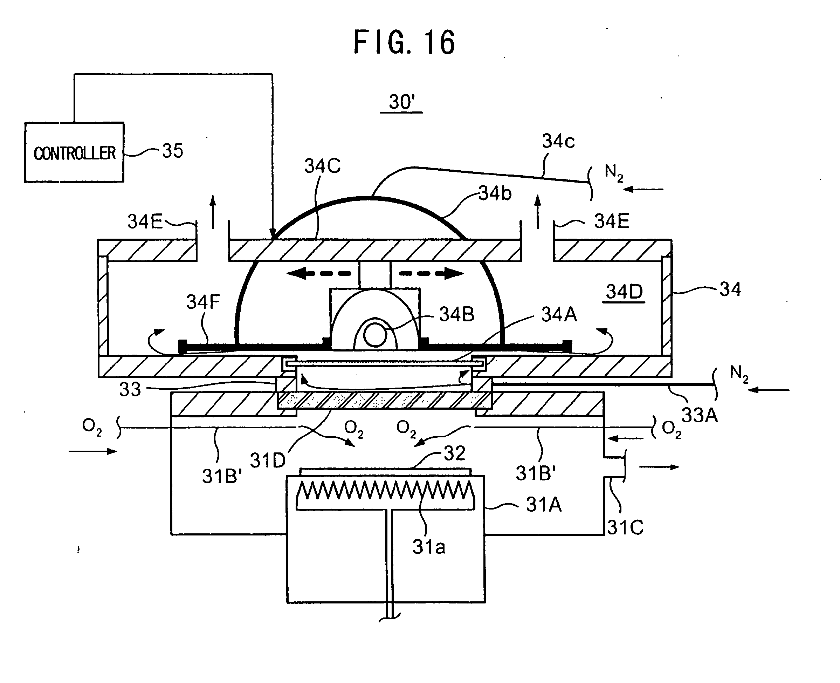

FIG.16 shows a substrate processing apparatus $30_1$ according to another modification of the substrate processing apparatus 30 of FIG.3, wherein those parts explained previously are designated by the same reference numerals and the description thereof will be omitted.

Referring to FIG.16, the quartz showerhead 31B is removed in the substrate processing apparatus $30_1$ and there are provided a plurality of gas inlets 31B' in the processing vessel 31 for introducing $O_2$ such that the gas inlets 31B' avoid the region on the substrate 32. Further, in the construction ot FIG.14, it should be noted that the quartz window 34A formed in the connection part 43 in correspondence to the ultraviolet exposure apparatus 34 in the construction of FIG.3 is removed.

According to such a construction the absorption of the ultraviolet radiation formed by the ultraviolet source 34B by the quartz window 34A or the showerhead 31B becomes minimum.

In the construction of FIG.3 or FIG.16, it is also possible to connect an evacuation duct to the evacuation port 34B according to the needs and discharge the exhaust of the ultraviolet exposure apparatus 34 to the environment after scrubbing.

[FOURTH EXAMPLE HELPFUL FOR UNDERSTANDING THE PRESENT INVENTION]

The inventor of the present invention has conducted an experiment of forming a $SiO_2$ film on a (100) surface of the Si substrate by using the substrate processing apparatus 30 explained previously with reference to FIG. 3 while changing the driving power of the ultraviolet optical source 34B and measuring the films thickness of the $SiO_2$ film thus obtained by an XPS (X-ray photoelectron spectroscopy) method. By conducting the film thickness measurement by XPS, it becomes possible to eliminate the effect of apparent change of film thickness of the $SiO_2$ film caused by the adsorbents ($H_2O$ or organics) contained in the air and adsorbed on the film surface as compared with the case of using ellipsometry, in which the film thickness measurement is conducted in the air. Thereby, more accurate measurement of film thickness becomes possible.

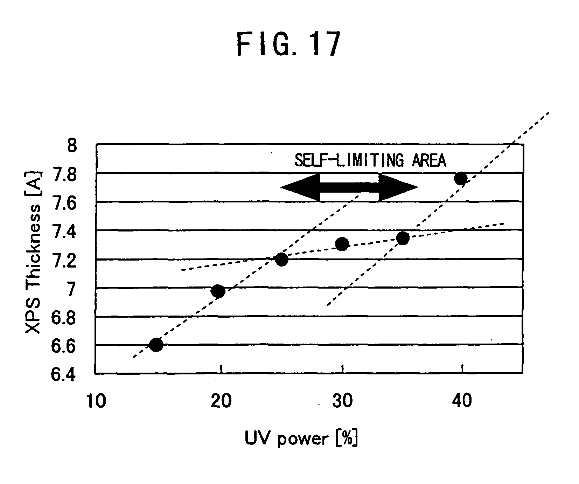

FIG.17 shows the relationship between the film thickness of the $SiO_2$ film thus obtained and the ultraviolet optical power. It should be noted that the experiment of FIG.17 is conducted for the case the power of the ultraviolet radiation is changed with the respect to a reference luminance of $50mW/cm^2$ realized in the region right underneath the optical source, within the range of 10 - 45%. Here it should be noted that the oxidation is conducted for the duration of 5 minutes. Further, it should be noted that the location of the optical source 34B is optimized according to the procedure explained with reference to FIG.9 in the experiment of FIG.17.

Referring to FIG.17, it can be seen that the thickness of the $SiO_2$ film as measured by the XPS method increases generally linearly from 0.66 nm to 0.72 nm with the luminance of the ultraviolet radiation in the case of the luminance is in the range of about 15 - 25% of the foregoing reference luminance. Further, it can also be seen that the film thickness increases generally linearly in the case the luminance is in the range of about 35% to 40% of the reference luminance. Further, it can be seen from FIG.17 that the thickness of this $SiO_2$ film changes only 0.01 nm from the thickness of 0.72 nm to 0.73 nm in the case with the luminescence of the word ultraviolet source is in the range of about 25 - 35% of the reference luminance.

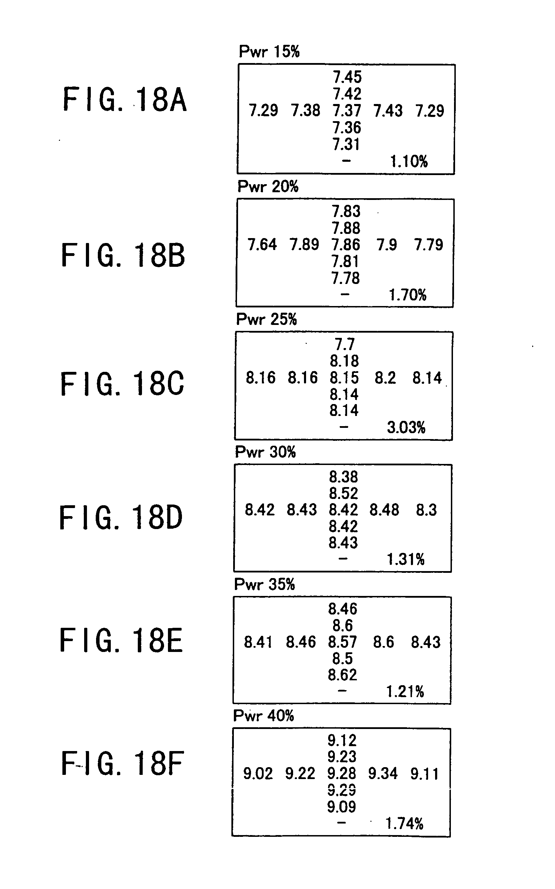

FIGS.18A - 18F show the thickness distribution of the $SiO_2$ film formed by the ultraviolet-activated oxidation processing step conducted on the a Silicon substrate used in the experiment of FIG.17.

Referring to FIGS.18A - 18F, it can be seen that the thickness variation of the $SiO_2$ film can be suppressed within 2% or less, by reducing the luminance of the ultraviolet radiation such that the $SiO_2$ film is formed with the thickness of 1.0nm or less, except for the case of FIG.18C of setting the luminance to 25% of the reference luminance. Particularly, by setting the ultraviolet luminance to 30% or 35% of the reference luminance as represented in FIG.18D or 18E, in other words, by setting the ultraviolet luminance to the luminance region shown in FIG.17 in which the increase of the films thickness of the $SiO_2$ film is small, it is possible to suppress the film thickness variation of the $SiO_2$ film to 1.21-1.31%.

Such remarkable improvement of uniformity of film thickness variation observed in the case the thickness of the $SiO_2$ film is reduced to 1.0 nm or less, particularly the step-like change of the $SiO_2$ film thickness with the ultraviolet radiation dose as observed in FIG.17, suggests the existence of a self control (self-limiting) effect in the ultraviolet-activated oxidation processing. It is thought that the step-like change of the $SiO_2$ film thickness observed in FIG.17, while being observed for the case the ultraviolet radiation power is changed, is also expected observed with regard to the process temperature or process duration.

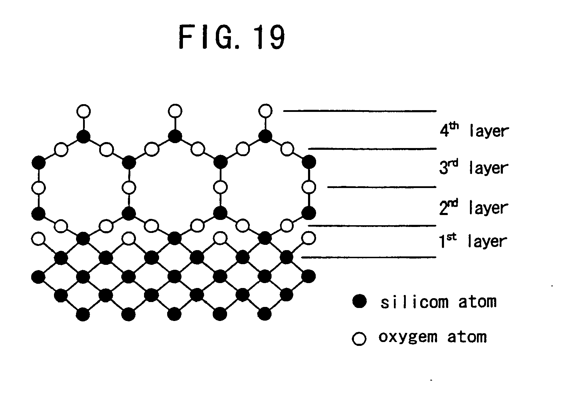

FIG.19 shows one possible mechanism of such self-limiting effect.

Referring to FIG.19, an $SiO_2$ film having a three-dimensional Si-O-Si network is formed on the surface of the Si substrate at the time of the oxidation process as a result of penetration of oxygen, wherein it should be noted that such a progress of oxidation process of the Si substrate starts from the location where the bonding of the Si atoms is weakest. In the case one whole atomic layer of the crystal constituting the substrate is oxidized as in the state of FIG. 19, on the other hand, the number of the sites of the weak bond necessary for causing the oxidation is reduced. Further, it becomes necessary to provide a large amount of activated oxygen in order to start a new oxidation phase in view of the need of the oxygen atoms to penetrate through the oxide film for causing the oxidation and in view of increased thickness of the oxide film. Thus, it is believed that such an increase of the active oxygen associated with the ultraviolet-activated oxidation processing also contributes to the slowdown of the oxide film growth. It is believed that the step-like growth of the oxide film shown in FIG.17 is caused as a result of the self-limiting effect associated with such atomic layer oxidation during the oxide film growth.

It is believed that the observed uniformity of the oxide film is maintained up to 5 - 6 layers in terms of the $SiO_2$ molecular layers.

From the results of FIGS. 17 and 18, it is preferable to conduct the ultraviolet-activated oxidation processing in the substrate processing apparatus 30 of FIG.3 such that the $SiO_2$ film has a thickness of 5 - 6 molecular layers or less, preferably 3 molecular layers or less.

[FIFTH EXAMPLE HELPFUL FOR UNDERSTANDING THE PRESENT INVENTION]

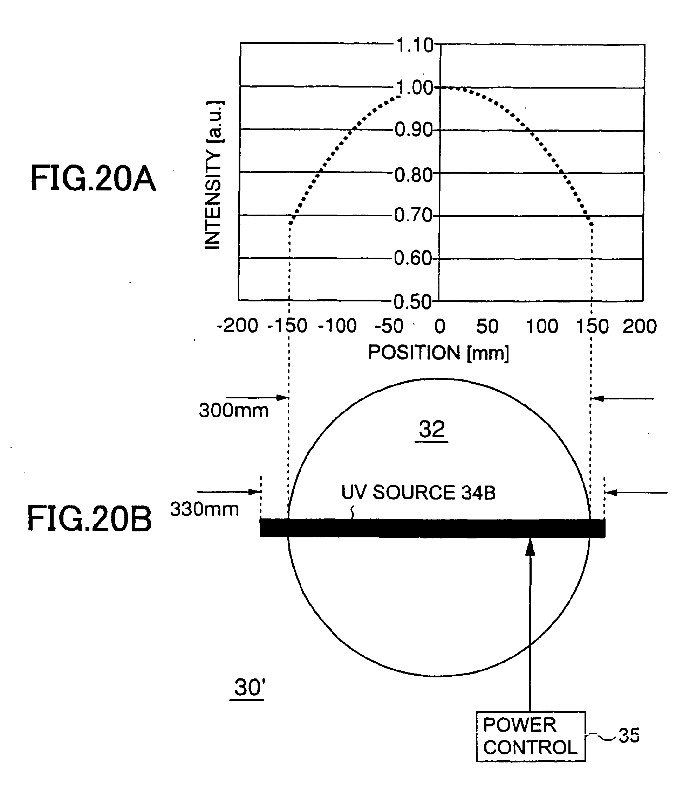

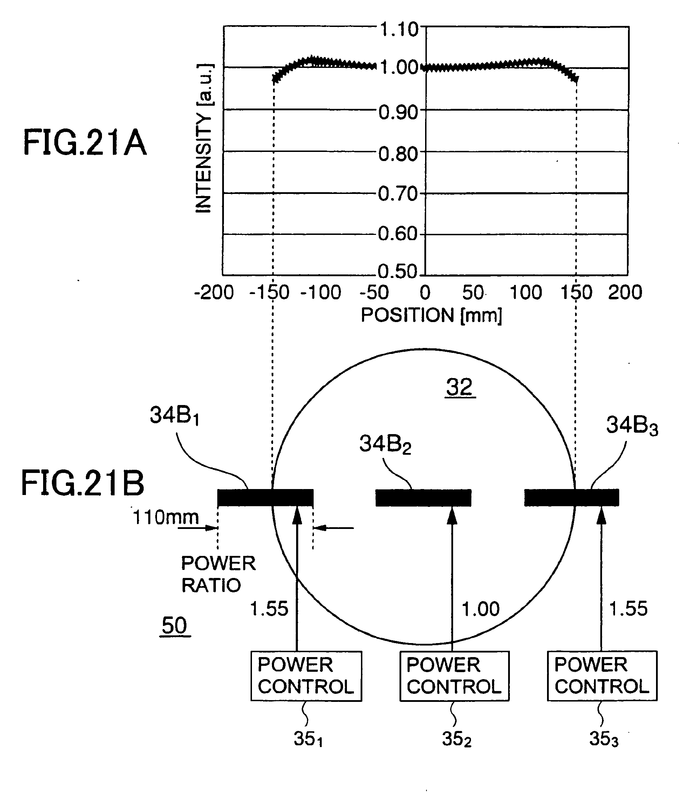

Next, a substrate processing apparatus 50 according to a fifth example helpful for understanding the present invention will be described with reference to FIGS.20A and 20B and FIGS.21A and 21B, wherein the substrate processing apparatus 50 is an expansion of the substrate processing apparatus 30' of the previous embodiment for handing large diameter substrate of the future.

Referring to FIGS.20A and 20B, FIG.20B shows the substrate processing apparatus 30' ofFIG.16 in a plan view, while FIG.20A shows the distribution of the ultraviolet radiation intensity on the substrate 32 for the case the substrate 32 has a diameter of 300mm. In FIG.20A, it should be noted that the illustrated radiation intensity distribution of FIG.20A represents the one measured at the location right underneath the ultraviolet source for the case the substrate 32 of 300mm diameter is irradiated with the linear ultraviolet source 34B having a length of 330mm from the height of 100mm above the substrate. In FIGS.20A and 20B, those parts corresponding to the parts described previously are designated by the same reference numerals and the description thereof will be omitted.

Referring to FIG.20A, it can be seen that the ultraviolet radiation intensity is decreased by as much as 30% at the edge part of the substrate 32 in the event the substrate processing apparatus 30' of FIG. 16 is used straightforward for the processing of the large-diameter substrate having a diameter of 300mm or more. In order to improve the uniformity of distribution of the ultraviolet radiation intensity for the processing of such large-diameter substrates, it is of course possible to increase the length of the linear optical source 34B. However, such an approach invites increase of size of the substrate processing apparatus and is not acceptable.

FIGS.21A and 21B show the construction of a substrate processing apparatus 50 according to the present example wherein the foregoing problems are eliminated. In FIGS.21A and 21B, those parts corresponding to the parts described previously are designated by the same reference numerals and the description thereof will be omitted. Similarly to FIGS.20A and 20B, FIG.21B shows the substrate processing apparatus 50 in a plan view while FIG.21A shows the distribution of the ultraviolet radiation intensity on the substrate 32.

Referring to FIG.21B, the present example constructs the linear ultraviolet source 34B by arranging a plurality of linear optical sources $34B_1$, $34B_2$ and $34B_3$ on a single line, and each of the optical sources are driven by a corresponding driving apparatus $35_1$, $35_2$ or $35_3$.

FIG.21A shows the optical intensity distribution in a region of the substrate 32 right underneath the ultraviolet source for the case the optical output of the ultraviolet sources $34B_1$, $34B_2$ and $34B_3$ are controlled to the ratio of 1:1.5:1.

As can be seen in FIG.21A, the variation of the ultraviolet radiation intensity, having the value reaching 30% in the case of FIG.20A, is now reduced to about 3.5%. Thus, by constructing the linear ultraviolet source 34B used in the substrate processing apparatus 30 of the first example explained with reference to FIG.3 or the substrate processing apparatus 30' explained with reference to FIG.16, with a plurality of linear ultraviolet radiation source elements, and by driving the foregoing plurality of ultraviolet radiation source elements individually, and further by moving the plurality of ultraviolet radiation source elements collectively so as to scan over the surface of the substrate 32, it becomes possible to form an oxide film of extremely uniform thickness on the substrate 32.

Further, by applying the optimum seeking procedure similar to one shown in the flowchart of FIG.9 to the foregoing output ratio of the ultraviolet source elements for seeking for the optimum drive condition corresponding to the optimum film thickness distribution, further improvement is achieved for the uniformity of film thickness by correcting the factors pertinent to the processing apparatus. In the present example, therefore, the ratio of the driving power is changed in the ultraviolet sources 34B1 - 34B3 in the present example in the step 1 of FIG.8 in place of specifying the scanning region and the result of film formation is evaluated in the step 3. Further, in the step 4, an optimum ratio of the driving power is selected in place of selecting the optimum scanning region.

[SIXTH EXAMPLE HELPFUL FOR UNDERSTANDING THE PRESENT INVENTION]

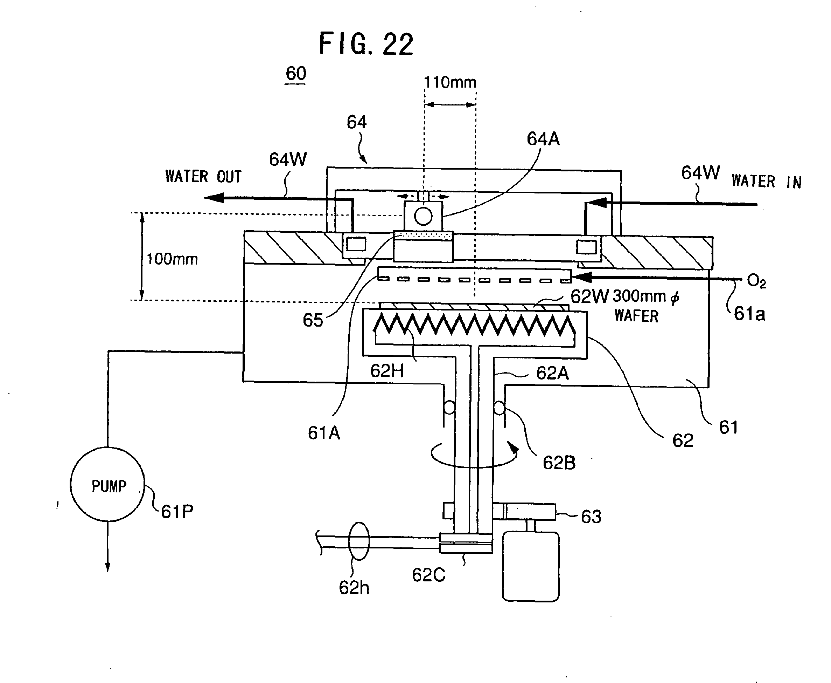

Next, the construction of a substrate processing apparatus 60 according to a sixth example helpful for understanding the present invention will be explained with reference to FIG.22. It should be noted that the substrate processing apparatus 60 is tuned up for further device miniaturization expected in the further and uses a rotating mechanism of the substrate in combination with one or more linear ultraviolet sources.

FIG.22 shows the construction of the substrate processing apparatus 60 according to an example helpful for understanding the present invention, wherein those parts corresponding to the parts described previously are designated by the same reference numerals and the description thereof will be omitted.

Referring to FIG.22, the substrate processing apparatus 60 includes a processing vessel 61 similar to the processing vessel 31 of the substrate processing apparatus 30 of the first example, and a stage 62 holding a substrate 62W of 300mm diameter is provided inside the processing vessel 61, wherein the stage 62 is rotated by a rotation driving part 63. Further, a single optical source unit 64 including a linear ultraviolet source 64A having a length of 330mm is provided above the processing vessel 61, and the ultraviolet optical source 64A irradiates the substrate on the stage 62 through the ultraviolet-transparent window 65. The processing vessel 61 is evacuated by a vacuum pump 61 P, and there is provided a quartz shower nozzle 61 A in the processing vessel 61 so as to face the substrate, wherein the shower nozzle 61A is supplied with $O_2$ via a line 61a. Further, the optical source unit 64 is provided with a cooling water passage and cooling water circulating through a line 64W cools the optical source unit 64. Further, the stage 62 is provided with a heat source 62H such as a heater for controlling the temperature of the substrate 62W.

In the construction of FIG.22, the stage 62 is connected to a rotary shaft 62A, wherein the rotary shaft 62A is provided with a vacuum seal 62B of a resin O-ring or more preferably of a magnetic fluid seal, such that the interior of the processing vessel 61 is sealed. Further, the ultraviolet source 64A is provided with offset from the center of the substrate as represented in FIG.22. The heat source 62H in the stage 62 is driven by a driving line 62h, wherein the driving line 62h extends to the outside of the processing vessel 61 via a contact 62C.

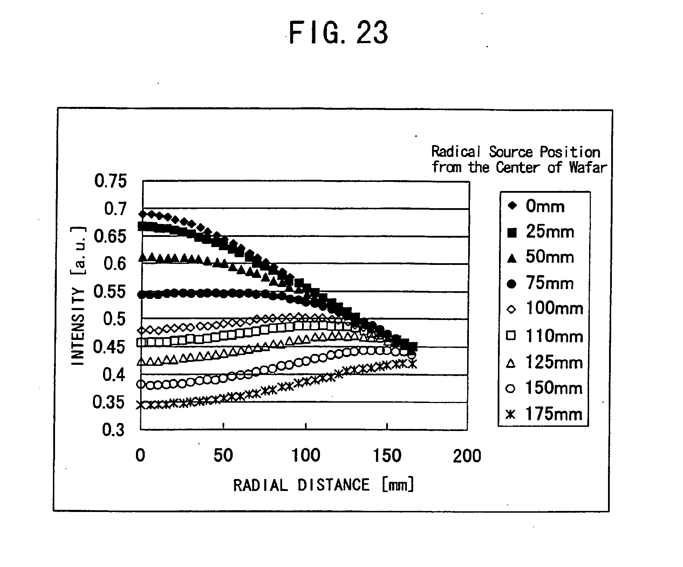

FIG.23 shows the radial distribution of the ultraviolet intensity on the substrate 62W for the case the substrate 62W is rotated in the substrate processing apparatus 60 of FIG.22 while changing the relative relationship between the ultraviolet source 64A and the substrate 62W variously. In FIG.23, it should be noted that the horizontal axis represents the radial distance of the substrate 62W while the vertical axis represents the average ultraviolet radiation intensity at each point. In FIG.23, it should be noted that the distance in the height direction (work distance) between the substrate 62W and the optical source 64A is set to 100mm.

Referring to FIG.23, the radiation intensity is maximum at the substrate center (0mm on the horizontal axis) and decreases toward the marginal part of the substrate when the optical source 64A is located near the center (such as 0mm) of the substrate 62W, as can be seen from the plot of the corresponding offset. In the case the ultraviolet source 64A is displaced from the center of the substrate 62W with a large distance such as 150mm, on the other hand, there appears a tendency in which the distribution of the radiation intensity is small at the center of the substrate and increases toward the substrate edge. Particularly, in the event the ultraviolet source 64A is disposed at the radial distance of 110mm from the center of the substrate 62A, it can be seen that the variation of intensity of the ultraviolet radiation becomes small and falls within the range of about 10%.

Thus, in the substrate processing apparatus 60 of FIG.22, it becomes possible to form an oxide film of extremely uniform thickness, by setting the ultraviolet source 64A at the location offset by the distance of 110mm from the center of the substrate 62W in the radial direction as represented in FIG.22 and by setting the height of the ultraviolet source 64A to 100mm, and by conducting the ultraviolet-activated oxidation processing while rotating the substrate 62W and the ultraviolet source 64A relatively with each other.

Further, it is also possible to modify the thickness distribution of the oxide film formed on the substrate 64A by displacing the ultraviolet source 64A from the optimum location within a limited range such as the range of 75 - 125mm, as represented by arrows in FIG.22. Further, it is also possible to achieve higher degree of uniformity for the oxide film by compensating for any factors causing non-uniform film thickness distribution pertinent to the substrate processing apparatus 60. In such a case, the flowchart explained with reference to FIG.9 seeking for the optimum film thickness distribution is applied for obtaining the optimum offset for the ultraviolet source 64A. Further, in the substrate processing apparatus 60 of the present example, it becomes possible to reduce the overall size of the apparatus in view of the limited moving range of the ultraviolet source 64A as compared with the substrate processing apparatus 30 or 30' of the first example.

[SEVENTH EXAMPLE HELPFUL FOR UNDERSTANDING THE PRESENT INVENTION]

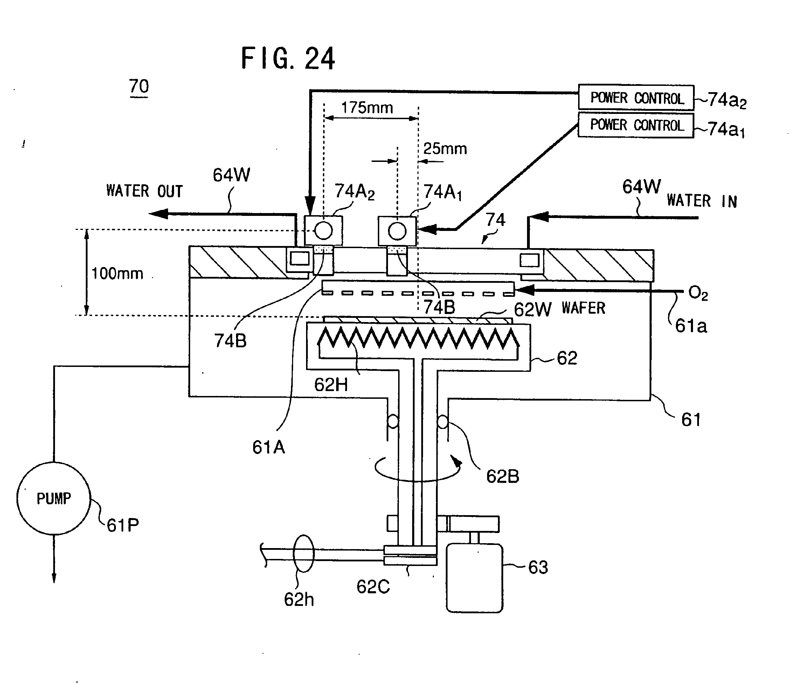

FIG.24 is a diagram showing the construction of a substrate processing apparatus 70 according to a seventh example helpful for understanding the present invention. In FIG.24, those parts corresponding to the parts described previously are designated by the same reference numerals and the description thereof will be omitted.

Referring to FIG.24, the present example has a construction similar to that of the substrate processing apparatus 60 of the previous example, except that there are provided a plurality of fixed ultraviolet sources $74A_1$ and $74A_2$ in place of the optical source unit 64 using a single movable ultraviolet source 64A, such that the fixed ultraviolet sources $74A_1$ and $74A_2$ are provided with offset from the center of the substrate 62W. Further, the fixed ultraviolet sources $74A_1$ and

$74A_2$ are driven by respective driving apparatuses $74a_1$ and $74a_2$. In the illustrated example, the ultraviolet source $74A_1$ is provided at a location offset by 25mm from the center of the substrate 62W in the radially outward direction, while the ultraviolet source $74A_2$ is provided at a location offset by 175mm from the center of the substrate 62W in the radially outward direction. Further, the optical source unit 74 is provided with a window 74B transparent to ultraviolet radiation in correspondence to the foregoing ultraviolet sources $74A_1$ and $74A_2$.

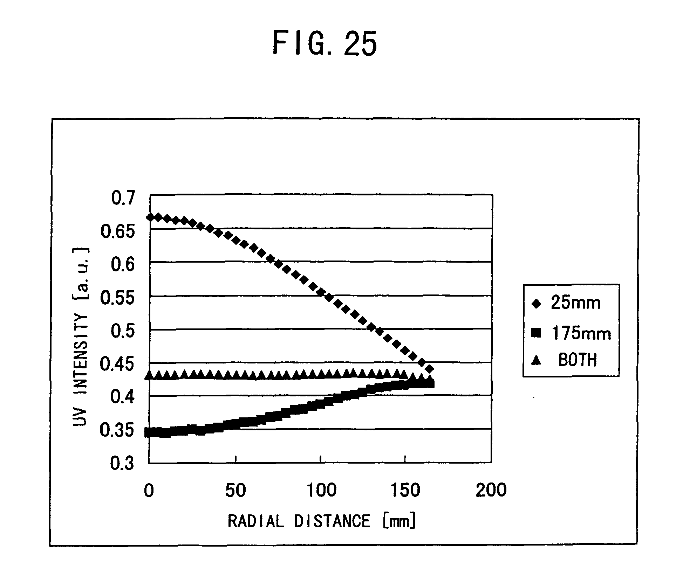

FIG.25 shows the intensity distribution of the ultraviolet radiation on the substrate 62W produced solely by the ultraviolet source $74A_1$ and the intensity distribution of the ultraviolet radiation produced on the substrate 62W solely by the ultraviolet source $74A_2$, together with the intensity distribution of the ultraviolet radiation for the case both of the ultraviolet radiation sources $74A_1$ and $74A_2$ are activated. In the experiment of FIG.25, it should be noted that the ultraviolet source $74A_1$ is provided with an offset of 25mm from the center of the substrate 62W in the radially outward direction, while the ultraviolet source $74A_2$ is provided with an offset of 175mm from the center of the substrate 62W in the radially outward direction. In the example of FIG.25, the ultraviolet radiation source $74A_1$ is driven by the driving apparatus $74a_1$ with a power of 73%, while the ultraviolet radiation source $74A_2$ is driven by the corresponding driving apparatus $74a_2$ with a power of 27%.

As can be seen from FIG.25, each of the ultraviolet sources $74A_1$ and $74A_2$ forms a monotonously changing intensity distribution for the ultraviolet radiation in the case the ultraviolet source is driven alone, while it will be also noted that the sense of the change is opposite. Thus, by optimizing the driving power of each of the ultraviolet sources $74A_1$ and $74A_2$, it becomes possible to realize a uniform distribution for the ultraviolet radiation on the substrate 62W. In the example of FIG.25, the variation of the ultraviolet radiation intensity is suppressed to the order of 2%. Such an optical driving power can be obtained by using the optimum seeking procedure explained already with reference to FIG. 9. Thereby, the driving power of the driving apparatuses $74a_1$ and $74a_2$ are changed in the step 1 and the result of film formation is evaluated in the step 3. Further, the optimum value is determined in the step 4.

[EIGHTH EXAMPLE HELPFUL FOR UNDERSTANDING THE PRESENT INVENTION]

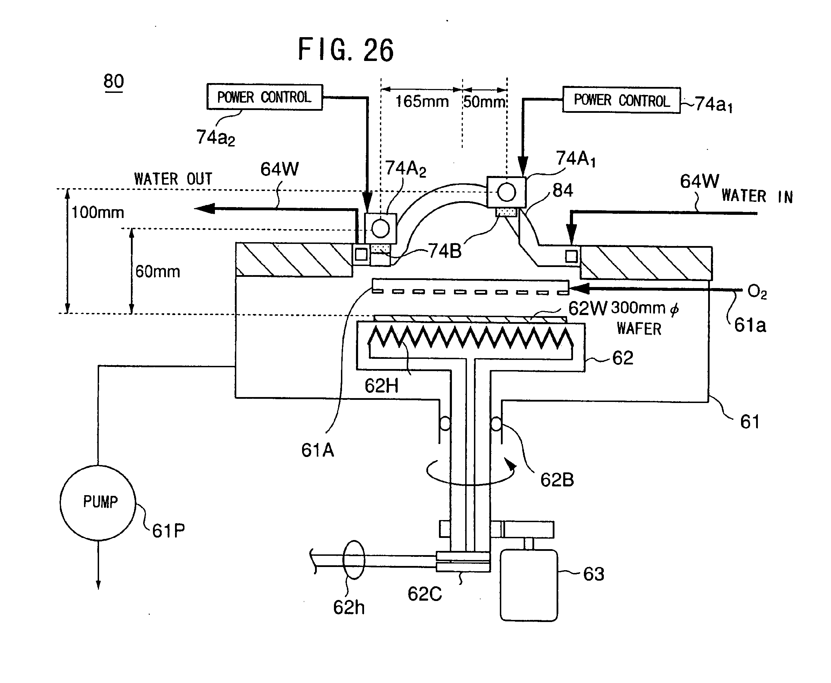

FIG.26 shows the construction of a substrate processing apparatus 80 according to an eighth example helpful for understanding the present invention, wherein those parts of FIG.26 corresponding to the parts explained previously are designated by the same reference numerals and the description thereof will be omitted.

Referring to FIG.26, the substrate processing apparatus 80 has a construction similar to that of the substrate processing apparatus 70 of the previous example, except that an optical source unit 84 formed of a bulging aluminum dome is provided in place of the optical source unit 74 of the substrate processing apparatus 70. On the optical source unit 84, it will be noted that the ultraviolet sources $74A_1$ and $74A_2$ are provided with different heights or different distances as measured from the surface of the substrate 62W.

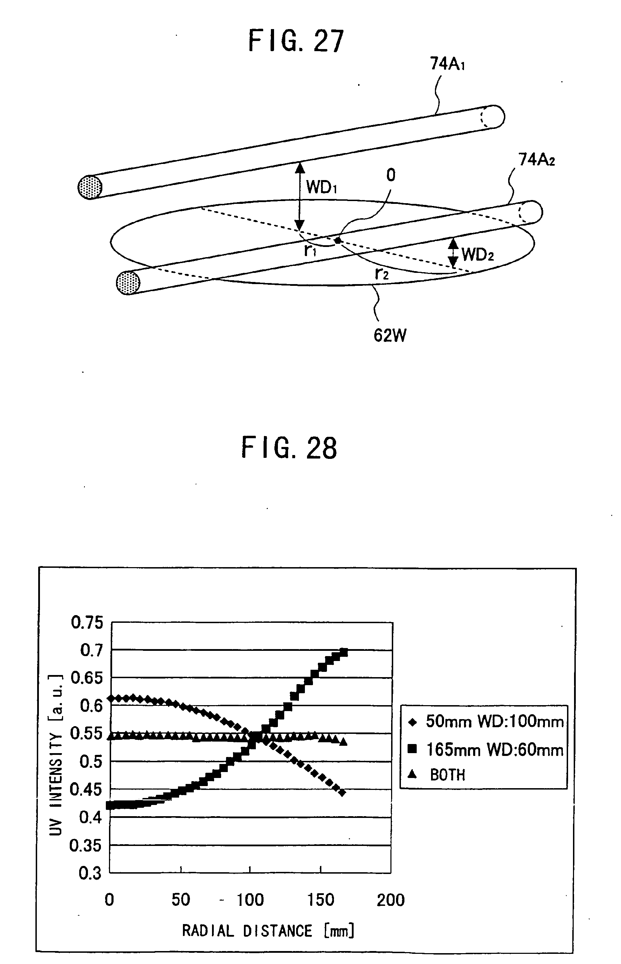

FIG.27 shows the relationship between substrate 62W and the ultraviolet source $74A_1$ or $74A_2$ in the substrate processing apparatus 80 of FIG.26.

Referring to FIG.27, the ultraviolet source $74A_1$ is provided with a first work distance $WD_1$ at a location offset by a distance r1 from the center O of the substrate 62W in the radial direction thereof, while the ultraviolet source $74A_2$ is provided with a second, smaller work distance $WD_2$ at a location offset by a larger distance r2 from the center O of the substrate 62W in the radial direction thereof.

Similarly to the substrate processing apparatus 70 explained before, the ultraviolet source $74A_1$ is driven by the driving apparatus $74a_1$ and the ultraviolet source $74_2$ is driven by the driving apparatus $74a_2$, independently from each other.

FIG.28 shows the intensity distribution of the ultraviolet radiation on the substrate 62W produced solely by the ultraviolet source $74A_1$ and the intensity distribution of the ultraviolet radiation produced on the substrate 62W solely by the ultraviolet source $74A_2$, together with the intensity distribution of the ultraviolet radiation for the case both of the ultraviolet radiation sources $74A_1$ and $74A_2$ are activated, for the case the distances r1 and r2 are set to 50mm and 165mm respectively and the work distances $WD_1$ and $WD_2$ are set to 100mm and 60mm respectively in the substrate processing apparatus 80 of FIG.26. In FIG.28, it should be noted that the ultraviolet source $74A_1$ is driven with the power of 64% while the ultraviolet source $74A_2$ is driven with the power of 36%.

Referring to FIG.28, it will be noted that the distribution of the ultraviolet optical radiation intensity changes monotonously in opposite directions between the ultraviolet source $74A_1$ and the ultraviolet source $74A_2$, and thus, it is possible to suppress the variation of the ultraviolet intensity to 2% or less, by superimposing the ultraviolet intensity distribution caused by the ultraviolet source $74A_1$ and the ultraviolet intensity distribution caused by the ultraviolet source $74A_2$.

In the present example, too, it is possible to obtain the optimum driving power of the ultraviolet sources $74A_2$ by the optimum seeking procedure similar to that of FIG.9.

[EMBODIMENT OF THE PRESENT INVENTION]

Next, description will be made on the substrate processing apparatus using a remote plasma source according to an embodiment of the present invention.

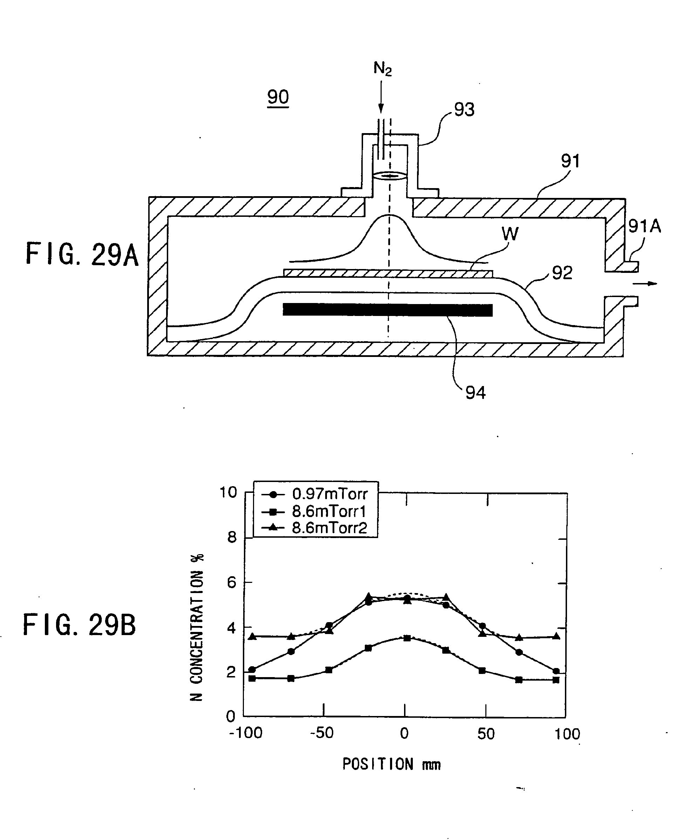

FIG.29A shows the construction of an ordinary remote plasma substrate processing apparatus 90, wherein it should be noted that the substrate processing apparatus 90 is the one used for conducting a nitridation processing for forming a nitride film on the surface of an $SiO_2$ film formed on a Si substrate as a result of nitridation reaction.

Referring to FIG.29A, the substrate 90 includes a processing vessel 91 evacuated from an evacuation port 91 A, wherein the processing vessel 91 is provided with a quartz stage 92 for holding a substrate W, and the processing vessel 91 carries thereon a remote plasma source 93 in the state that the remote plasma source 93 faces the substrate W, wherein the remote plasma source 93 is supplied with a $N_2$ gas and forms active $N_2$ radicals by activating the same with plasma. Further, a heater 94 is formed underneath the quartz stage 92 in correspondence to the substrate W. FIG. 29A further shows the distribution of the $N_2$ radicals formed by the remote plasma source 93. Naturally, the concentration of the $N_2$ radicals becomes maximum at the part right underneath the remote plasma source 93. In the case the remote plasma source 93 is provided at the center of the substrate W, the concentration of the $N_2$ radicals becomes maximum at the center of the substrate W.

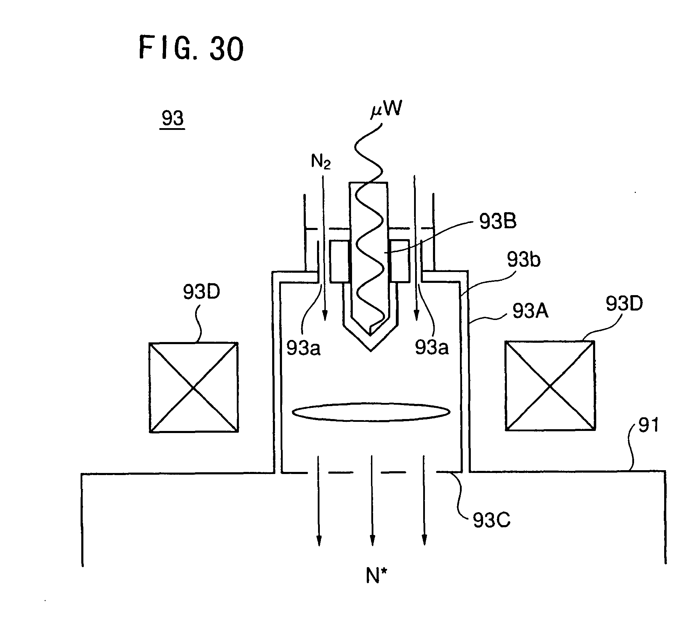

FIG.30 shows the construction of the remote plasma source 93 in detail.

Referring to FIG.30, it will be noted that the remote plasma source 93 includes a main body 93A having a first end mounted on the processing vessel 91, wherein the main body 93A further includes a quartz liner 93b, and an inlet 93a of a plasma gas such as $N_2$, Ar or the like, is formed at the other end of the main body 93A. Further, the remote plasma source 93 includes an antenna 93B at the aforesaid the other end of the main body 93A and the a quartz diffusion plate 93 formed at the foregoing first end of the main body 93, wherein the antenna 93B is supplied with a microwave while the quartz diffusion plate 93C supplies the active radicals formed in the remote plasma source 93 to the processing vessel 91 via a number of openings. Further, there is provided a magnet 93D outside the main body 93A between the foregoing first end and the foregoing the other end. In such a remote plasma source 93, therefore, plasma is formed in the main body 93A in correspondence to the location of the magnet 93D by supplying an $N_2$ gas or Ar gas into the main body 93A via the gas inlet 93a and by supplying a microwave to the antenna 93B. The plasma thus formed cause activation of the $N_2$ gas, and the nitrogen radicals N* formed as a result are introduced into the processing vessel 91 through the diffusion plate 93C.

FIG.29B shows the concentration of N on the substrate surface for the case an SiON film is formed on an Si substrate W formed with the $SiO_2$ film by the substrate processing apparatus 90 of FIG.29A under various conditions, wherein it should be noted that the N distribution in FIG.29B represents the profile as measured in the radial direction with regard to the origin chosen at the center of the substrate W.

Referring to FIG.29B, it can be seen that there is formed a non-uniform distribution of N on the substrate W and that the N concentration becomes maximum at the center of the substrate W. Further, it will be noted that the N distribution is generally symmetric with regard to the center of the substrate W. This means that it is not possible to achieve a uniform distribution of N even when the substrate is rotated, in view of the fact that there is formed such a symmetric distribution ofN.

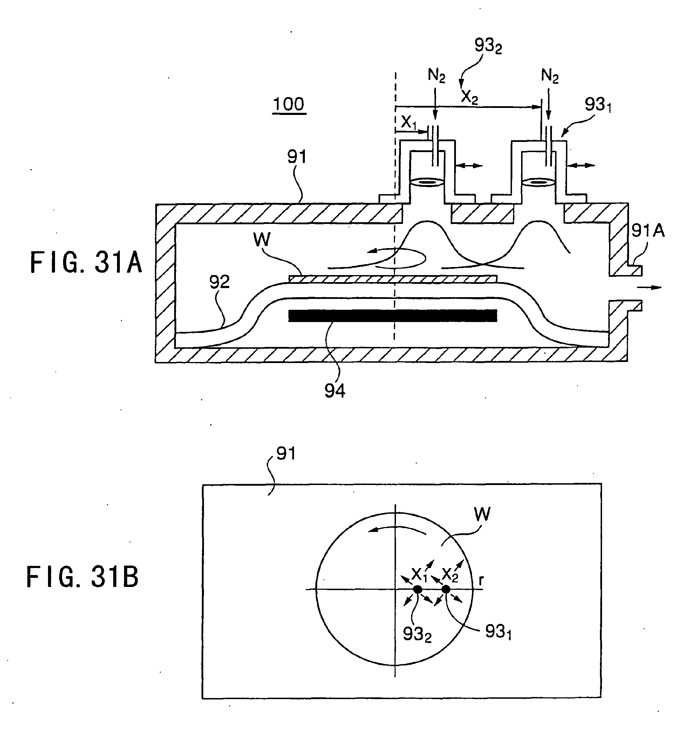

FIGS.31A and B show the construction of a substrate processing apparatus 100 according an embodiment of the present invention, wherein it should be noted that FIG.3 1 A shows the cross-sectional view while FIG.31B shows a plan view. In FIGS.31A and 31B, those parts corresponding to the parts described previously are designated by the same reference numerals and the description thereof will be omitted.

Referring to FIGS.31A and 31B, it will be noted that there are provided a plurality of remote plasma sources $93_1$ and $93_2$ at respective locations ($x_1$, O) and ($x_2$, o) with offset from the center of the substrate W, and as a result, there is formed a radical distribution on the substrate W such that the distributions of the radicals originating from these remote plasma sources are superimposed. Thus, by rotating the substrate W as represented in FIGS.31A and 31B, the radical distribution on the substrate W is averaged.

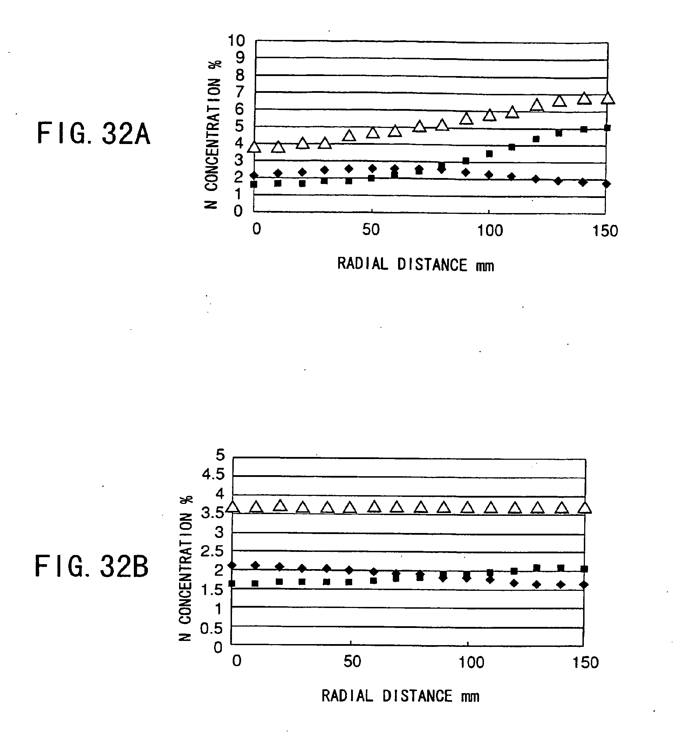

FIG.32A shows the distribution of N on the substrate W after the nitridation processing for the case in which the substrate W is fixed and not rotated. In FIG.32A, it should be noted that a Si substrate formed with an $SiO_2$ film on the surface thereof is used for the substrate W. On the other hand, FIG.32B shows the distribution of N on the substrate surface for the case the nitridation processing has been conducted while rotating the substrate W about a center thereof. In FIGS.32A and 32B, the points represented by ■, ♦; and △ correspond respectively to the cases of forming an SiON film in which only the remote plasma source $93_1$ is used, only the remote plasma source $93_2$ is used, and both of the remote plasma sources $93_1$ and $93_2$ are used.

Referring to FIG.32A, it will be noted that a N distribution changing gently in the radial direction of the substrate is obtained for the case the substrate W is not rotated, while in the case the substrate W is rotated, an extremely uniform N concentration is obtained.

In the substrate processing apparatus 100 of FIGS.31A and 31B, it should be noted that the foregoing remote

plasma sources $93_1$ and $93_2$ are provided on the processing vessel 91 movably as represented by arrows in FIGS.31A and 31B so as to enable uniform N distribution represented in FIG.32B for the case the substrate is rotated, and that the remote plasma sources $93_1$ and $93_2$ are fixed at the optimum locations providing the uniform N distribution represented in FIG.32B.

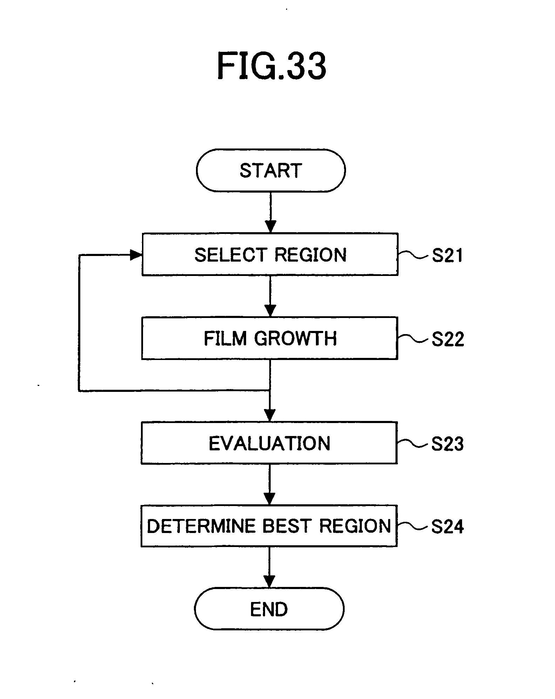

FIG.33 shows the flowchart for seeking for such optimum locations.

Referring to FIG.33, an arbitrary location on the substrate is specified for the remote plasma sources $93_1$ and $93_2$ in the first step 21, and the remote plasma sources $93_1$ and $93_2$ are fixed on the processing vessel 91 at the foregoing specified locations. Next, in the step 22, the substrate W is introduced into the substrate processing apparatus 100 and the formation of an SiON film is conducted by driving the remote plasma sources $93_1$ and $93_2$ while rotating the substrate W. Further, by repeating the steps 21 and 22, new SiON films are formed on new substrates W while displacing the location of the remote plasma sources $93_1$ and $93_2$ each time.

The N distribution of the SiON film thus obtained is evaluated for each of the experiments in the step 23, and the optimum location for the remote plasma sources $93_1$ and $93_2$ that minimizes the variation of the concentration is determined in the step 24.

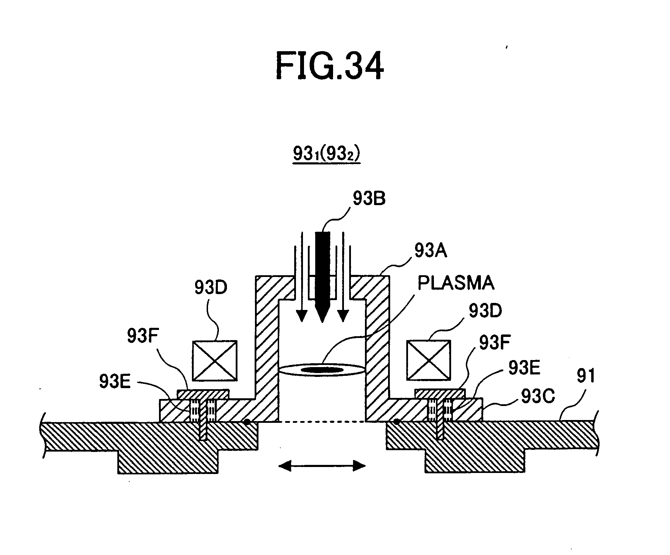

FIG.34 shows the mechanism of mounting the remote plasma sources $93_1$ and $93_2$ on the processing vessel 91 in a movable manner, wherein those parts of FIG.34 explained previously are designated by the same reference numerals and the description thereof will be omitted.

Referring to FIG.34, it will be noted that the main body 93A is provided with a mounting flange 93c for engagement with an outer wall of the processing vessel 91, and the main body 91A is fixed on the processing vessel 91 by screwing the mounting flange 93c at screw holes 93E by using screws 93F. In such a construction of FIG.34, it should be noted that the screw holes 93E are formed larger than the screws 93F, and thus, the main body 93A is movable in the direction of the arrows when the screws 93F are loosened.

In the construction of FIG.34, it is also possible to eliminate the screws 93F and the screw holes 93E and form the flange 93c so as to slide with respect to the outer wall of the processing vessel 91.

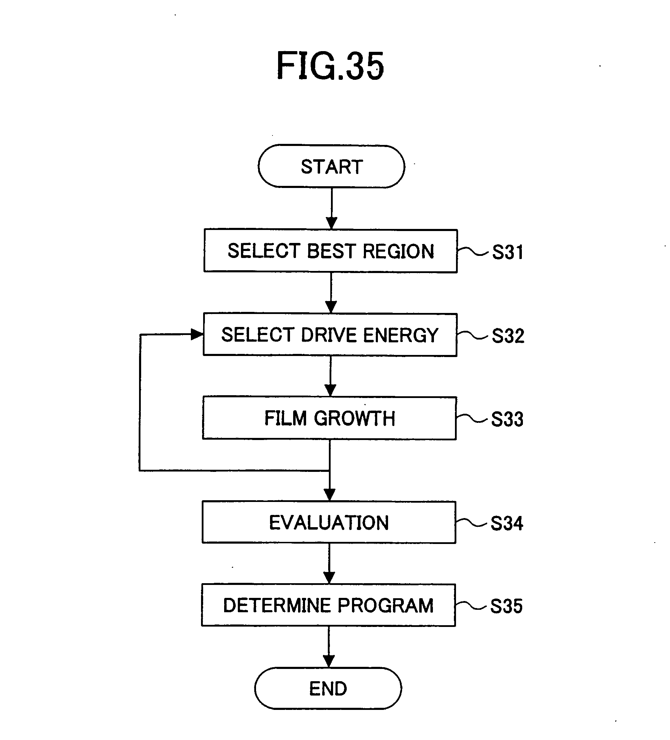

Further, in the present embodiment, the driving power is optimized as represented in FIG.35 after the optimization for the location of the remote plasma sources $93_1$ and $93_2$.

Referring to FIG.35, the optimum location searched by the procedure of FIG.33 is specified for the remote plasma sources $93_1$ and $93_2$ in the first step 31, and the driving energy is specified in the step 32 for the remote plasma sources $93_1$ and $93_2$. Further, in the step 33, the substrate W is introduced into the substrate processing apparatus and the remote plasma sources $93_1$ and $93_2$ are driven on the substrate W at the respective, specified locations with the driving energy specified in the step 32. As a result, there is formed an SiON film. Further, by repeating the steps 21 and 22, new SiON films are formed on new substrates W each time the location of the remote plasma sources $93_1$ and $93_2$ are displaced.

Further, in the step 34, the distribution of nitrogen in the SiON film is evaluated for each of the experiments, and the optimum driving energy that minimizes the variation of the concentration is determined for the remote plasma sources $93_1$ and $93_2$. Further, in the step 35, a control program for controlling the remote plasma sources $93_1$ and $93_2$ of the substrate processing apparatus 100 is determined such that the film formation is achieved under such optimum driving energy.

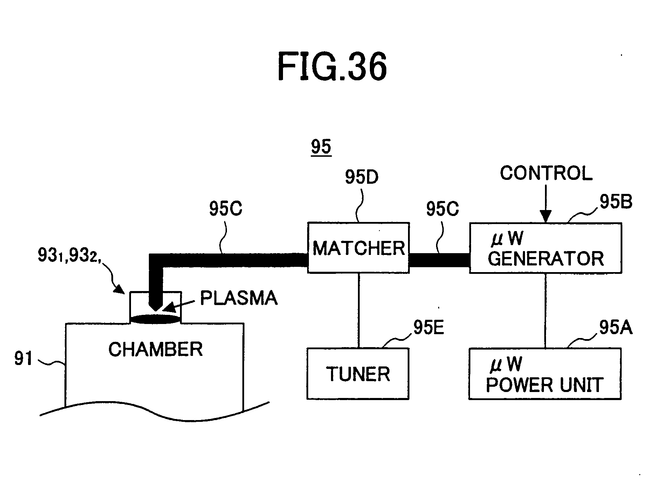

FIG.36 shows the construction of a driving circuit 95 of the remote plasma sources $93_1$ and $93_2$.

Referring to FIG.36, the driving circuit 95 includes a microwave generator 95B driven by a microwave power supply 95A, and the microwave produced by the microwave generator 95B typically with a frequency of 2.45GHz is supplied to an impedance matcher 95D via a waveguide 95C. The microwave is then fed to the foregoing antenna 93B. Further, it should be noted that the driving circuit 95 is provided with a tuning circuit 95E for matching the impedance of the impedance matcher 95D with the impedance of the antenna 93B.

According to the driving circuit 95 of such a construction, it is possible to optimize the driving energy of the remote plasma sources $93_1$ and $93_2$ by controlling the microwave generator 95B in the step 32 of FIG.35.

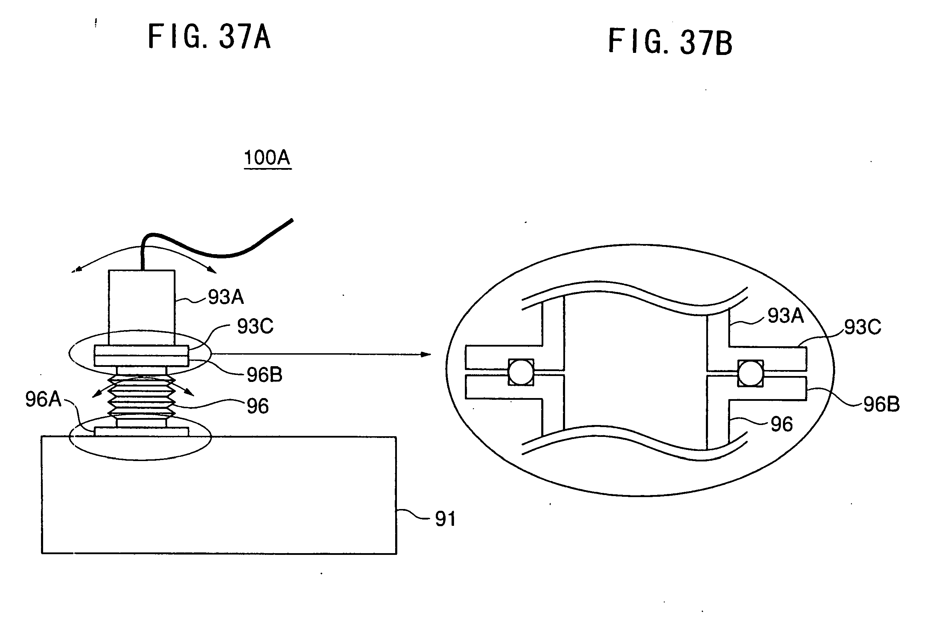

FIGS.37A and 37B show the construction of a substrate processing apparatus 100A according to a modification of the present embodiment, wherein FIG.37B is an enlarged cross-sectional diagram showing a part of FIG.37A in an enlarged scale.

Referring to FIGS.37A and 37B, it should be noted that a bellows 96 having flange parts 96A and 96B are mounted on the substrate processing vessel 91 by the foregoing flange part 96A, and the main body 93A of the remote plasma source $93_1$ or $93_2$ is mounted on the bellows 96 by engaging the mounting flange 93c with the flange 96B.

In the substrate processing apparatus 100A of such a construction, it is possible to change the angle of the remote plasma source with respect to the substrate W by deforming the bellows 96, and thus, it is also possible to determine an optimum angle for the remote plasma sources $93_1$ and $93_2$ in the step of FIG.33 explained before, in place of determining the optimum locations.

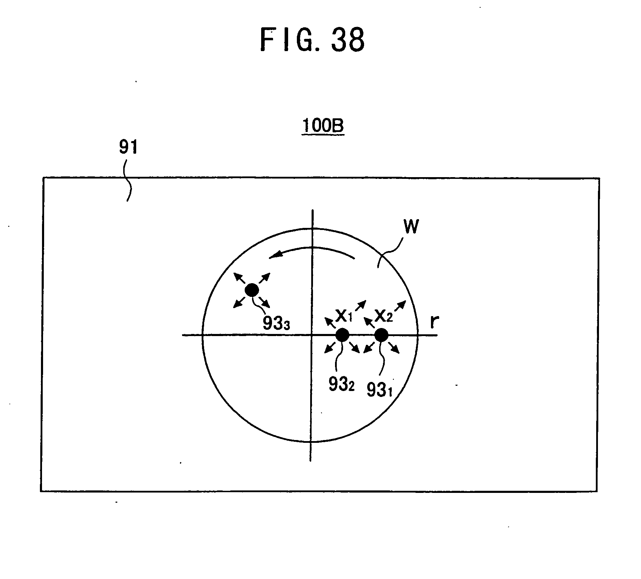

FIG. 38 shows the construction of a substrate processing apparatus 100B not in accordance with claim 6, wherein those parts corresponding to the parts described previously are designated by the same reference numerals and the description thereof will be omitted.

Referring to FIG.38, the substrate processing apparatus 100B includes a third remote plasma source $93_3$ movably as represented by arrows in addition to the foregoing remote plasma sources $93_1$ and $93_2$, wherein it should be noted that the present invention is effective also for such a substrate processing apparatus having three or more remote plasma sources.

Further, the present embodiment is effective not only for the formation of an SiON film conducted by nitridation of an Si substrate formed with an $SiO_2$ film, but also for the formation of an $SiO_2$ film by way of oxidation reaction or formation of an SiN film, or formation of a high-K dielectric film such as a $Ta_2O_5$ film, a $ZrO_2$ film, a $HfO_2$ film, a $ZrSiO_4$ film, a $HfSiO_4$ film, and the like, which is conducted by a CVD process.

[NINTH EXAMPLE HELPFUL FOR UNDERSTANDING THE PRESENT INVENTION]

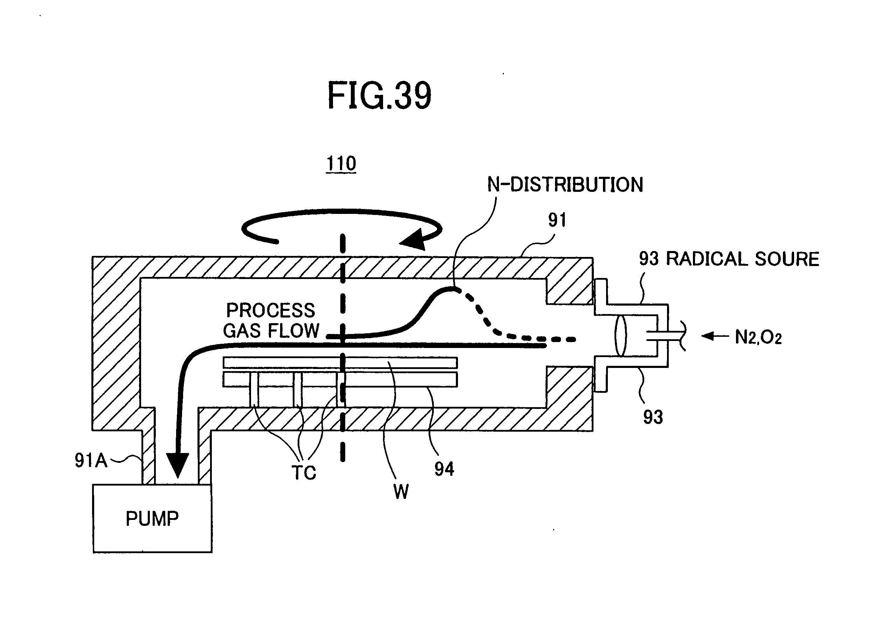

FIG.39 shows the construction of a substrate processing apparatus 110 according to a ninth example helpful for understanding the present invention, wherein those parts corresponding to the parts described previously are designated by the same reference numerals and the description thereof will be omitted.

Referring to FIG.39, the remote plasma radical source 93 is provided on a sidewall of the processing vessel 91, and the radicals introduced from the remote plasma radical source 93 are caused to flow along the surface of the substrate W in the processing vessel 91. Further, the radicals thus traveled are discharged from an evacuation port 91A provided at an end of the processing vessel opposing the remote plasma radical source 93. Thus, in the substrate processing apparatus 110, there is formed a radical flow flowing along the surface of the substrate W.

In the processing vessel 91, it should be noted that the substrate W is held rotatably and a plurality of thermocouples TC are provided at different radial locations underneath the substrate W for the measurement of temperature distribution. In the present example, the substrate W is rotated by a rotating mechanism not illustrated.

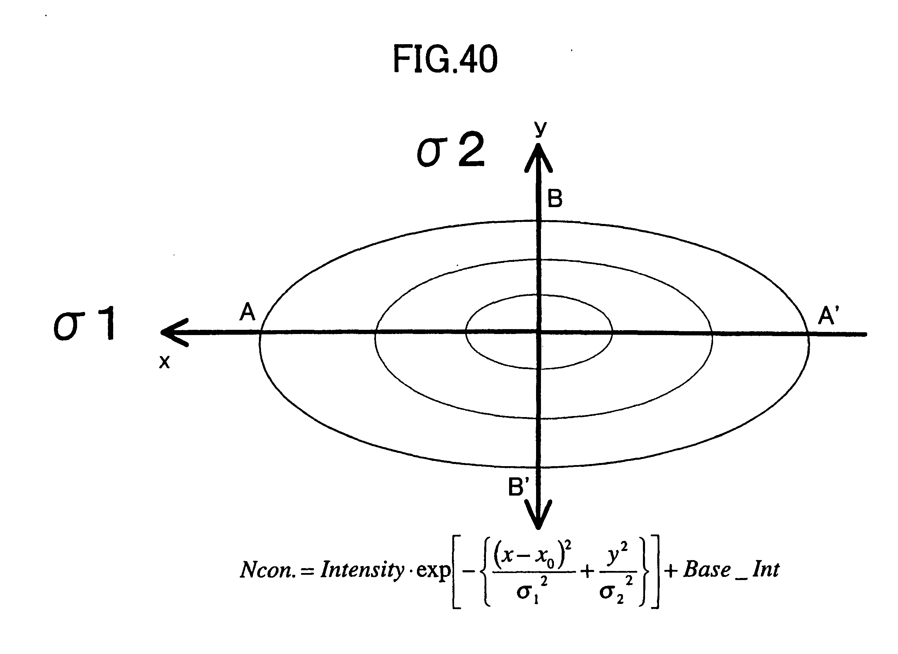

FIG.40 shows the representation form of the radical distribution formed inside the processing vessel 91 of the substrate processing apparatus 110 of FIG.39.

Referring to FIG.40, the radicals released from the radical source 93 are believed to form an ordinary, Gaussian distribution in the case there is no radical flow inside the processing vessel 91. In the present example, on the other hand, there is formed a radical flow inside the processing vessel 91 such that the radicals are caused to flow on the substrate W from the plasma radical source 93 to the evacuation port 91 as explained before. Thus, in order to investigate the effect of such a radical flow on the distribution of the radicals, the present invention employs the representation:

$$Ncon. = Intensity * \exp\left[-\left\{\frac{(x-x_0)^2}{\sigma_1^2}+\frac{y^2}{\sigma_2^2}\right\}\right] + Base_Int. \quad (1)$$

for representing the radical distribution, wherein it should be noted that the representation is an expansion of the ordinary Gaussian distribution by employing the coordinate axis x set in the direction parallel to the flow direction and the coordinate axis y set in the direction perpendicular to the x-axis. In Eq. (1), it should be noted that $\sigma$ 1 and $\sigma$ 2 are characteristic parameters or concentration distribution parameters for the case the actual concentration parameters are fit by using Eq.(1). Thereby, $\sigma$ 1 represents the degree of expansion of the radical distribution in the direction of the x-axis, while $\sigma$ 2 represents the degree of expansion of the radical distribution in the direction of the y-axis. By using the concentration distribution parameters $\sigma$ 1 and $\sigma$ 2, elliptical contours represented in FIG.40 are obtained for the radical distribution for the case of viewing the radical distribution from the direction perpendicular to the substrate W. In Eq.(1), it should be noted that the term "Base_Int" represents the base concentration value of the radicals, and the maximum value of the radical concentration is given by the sum of Base_Int and the concentration represented by the Gaussian. The radical distribution thus represented coincides with the distribution after the nitrogen radical processing has been conducted by using the substrate processing apparatus 110.

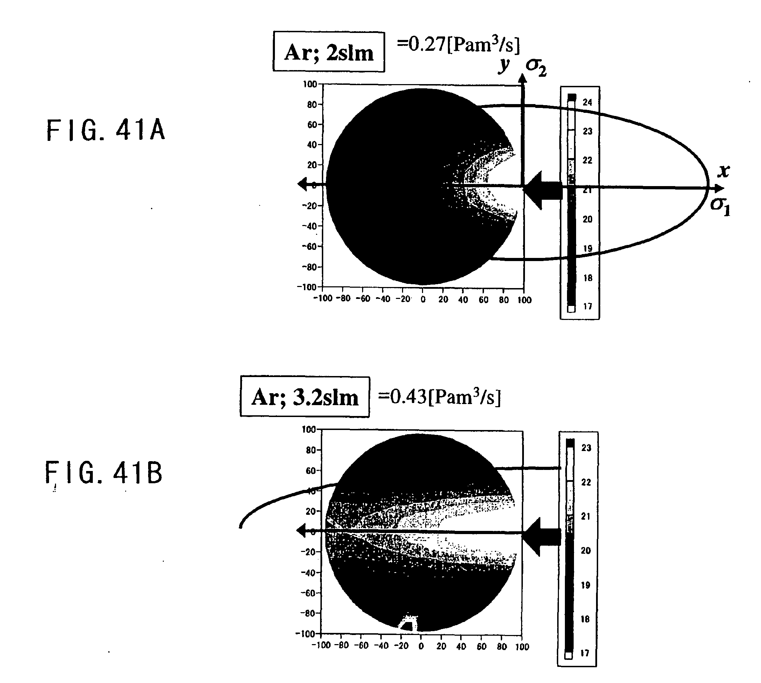

FIGS.41A and 41B show the value of the concentration distribution parameters $\sigma$ 1 and $\sigma$ 2 for the distribution of the nitrogen radicals respectively for the case the flow rate of the Ar plasma gas supplied to the plasma radical source 93 is set to 2SLM (=0.27Pa.m$^3$/sec) and 3.2SLM (=0.43Pa.m$^3$/sec), wherein it should be noted that there is formed an $SiO_2$ film on the surface of the substrate W in FIGS.41A and 41B and a part of the $SiO_2$ film is converted to an oxynitride film by introducing nitrogen as a result of the nitrogen radical processing. FIGS.41A and 41B show the film thickness distribution of the $SiO_2$ film or the oxynitride film thus formed on the substrate W, wherein it should be noted that the film thickness shown in FIGS.41A and 41B is an apparent thickness obtained by ellipsometry. In the case of using ellipsometry, it should be noted that there is caused a change of refractive index in the part where nitrogen is incorporated, and as a result, an apparently larger film thickness is tend to be observed.

Referring to FIG.41A, it will be noted that the nitrogen radicals reach the central part of the substrate W in the event the Ar gas flow rate is set to 2SLM. Thus, the parameter σ 1 characterizing the nitrogen radical distribution realized in such a state has a value of as large as 200mm, while it is noted that the parameter σ 2 takes a value of about 80mm. On the other hand, it should be noted that there exist no radicals in this case that reach the opposite side of the substrate across the central part of the substrate W. This means that the radicals are annihilated in such an opposite region as a result of recombination, or the like.

In the case the Ar gas flow rate is set to 3.2SLM as represented in FIG.41B, on the other hand, the radicals can flow across the surface of the substrate W before causing recombination because of the large velocity, and as a result, there appears a radical distribution characterized by the parameter σ 1 much larger than the case of FIG.41A. Even in this case, the parameter σ 2 takes a value of about 80 μm, similarly to the case of FIG.41A.

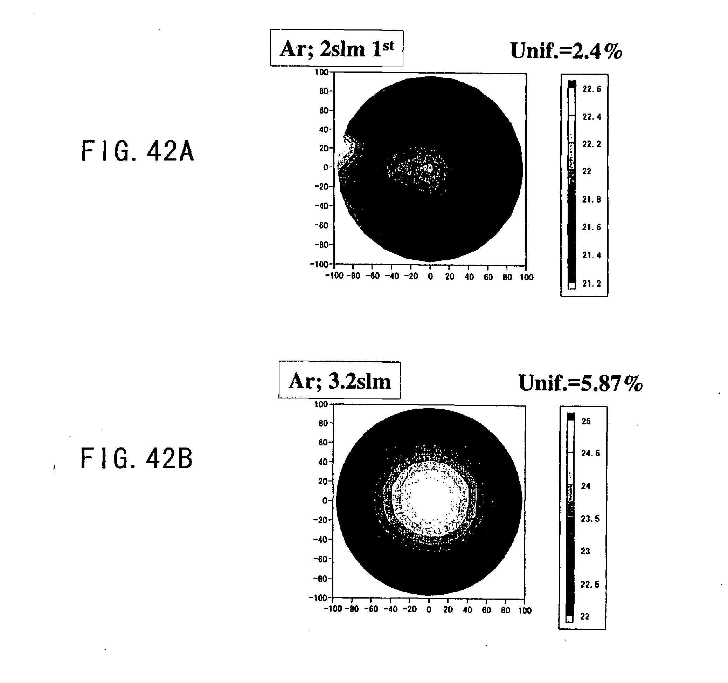

FIGS.42A and 42B show the distribution of the nitrogen radicals on the surface of the substrate W for the case the substrate W is rotated in the cases of FIGS.41A and 41B respectively, wherein the illustrated distribution is represented in terms of the film thickness distribution observed by ellipsometry.

Comparing FIGS.42A and 42B, it can be seen that the nitrogen radical distribution of FIG.41A is averaged as a result of rotation of the substrate W, and as a result, there is realized excellent uniformity in which the variation is improved up to 2.4%. In the case of the radical distribution of FIG.41B, on the other hand, it can be seen that there is formed a large radical peak at the central part of the substrate as a result of rotation of the substrate W. This clearly reflects the situation of FIG.41B showing the existence of radicals with substantial concentration at the central part of the substrate W. As a result, it can be seen that the variation has been increased to 5.9% in this case.

On the other hand, in the case the parameter σ 2 takes a large value of about 300 μm, the distribution of the radicals on the surface of the substrate W is averaged by rotating the substrate W, and it becomes possible to suppress the variation to the value of 3% or less even in such a case in which the parameter σ 1 takes a large value and the radicals reach the opposite region of the substrate W.

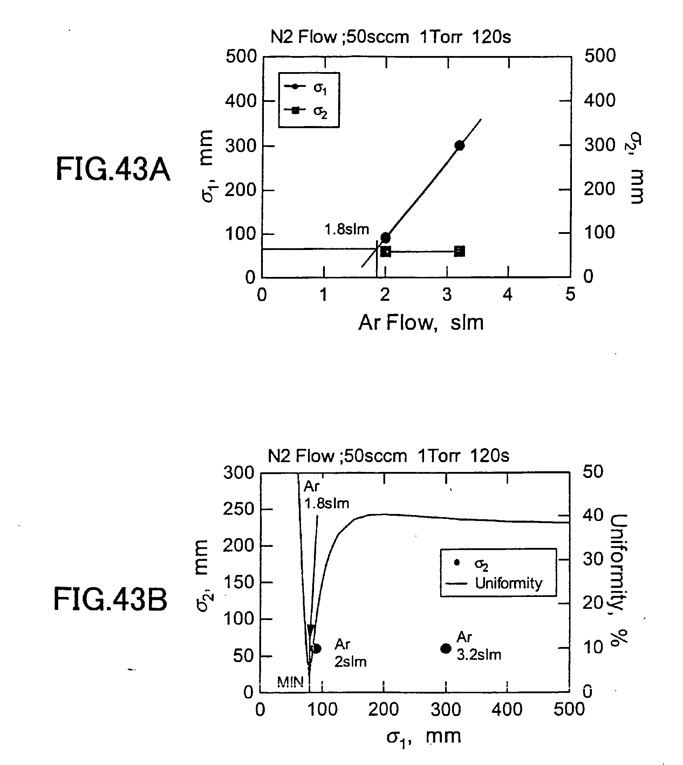

FIG.43A shows the relationship between the flow rate of the Ar gas supplied to the plasma radical source 93 and the foregoing concentration distribution parameters σ 1 and σ 2. In FIG.43A, it should be noted that the flow rate of the $N_2$ gas is set to 50 SCCM and the substrate processing is conducted under the pressure of 1 Torr (133Pa) for 120 seconds.

As can be seen from FIG.43A, the concentration distribution parameter σ 2 does not change substantially when the Ar flow rate is changed, while the concentration distribution parameter σ 1 changes significantly with such a change of the Ar flow rate.

FIG.43B shows the relationship between the concentration distribution parameter σ 1 and the uniformity of the nitrogen radical concentration for the case the substrate W is rotated, wherein it should be noted that the uniformity of the nitrogen radicals is represented by the rate of concentration variation similarly to the case of FIG.42A,B. Thus, an ideal uniformity is realized in the case the rate of concentration variation is 0%. In FIG.43B, it should be noted that the relationship between the parameters σ 1 and σ 2 is, although there are only two point, also represented. In FIG.43B, too, the flow rate of the $N_2$ gas is set to 50 SCCM and the substrate processing is conducted under the pressure of 1 Torr (133Pa) for 120 seconds.

Referring to FIG.43B, it can be seen in the illustrated example that the foregoing rate of concentration variation takes a very large value in the case the concentration distribution parameter σ 1 is less than 80mm. Further, it can be seen that the rate of concentration variation takes the value of about 40% in the event the concentration distribution parameter σ 1 is 150mm or more. Furthermore, it can be seen that there exists a point in which the rate of concentration variation takes a minimum value of 2 - 3% in the case the concentration distribution parameter σ 1 takes the value of about 80mm. From the relationship of FIG.43A, it can be seen that the Ar gas flow rate corresponding to the foregoing concentration distribution parameter σ 1 minimizing the rate of concentration variation is about 1.8SLM.

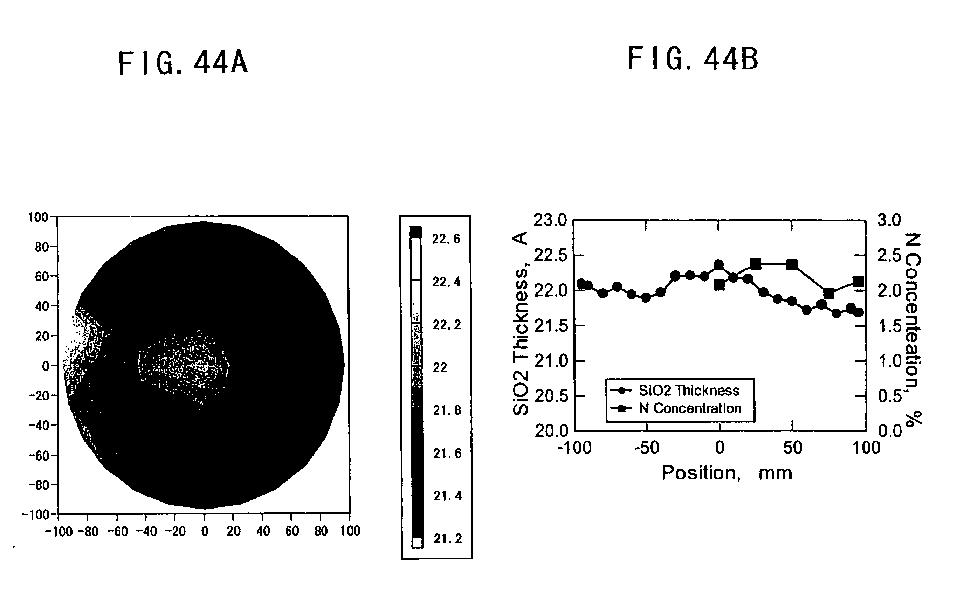

FIGS.44A and 44B show the thickness distribution of the oxynitride film formed for the case the oxide film on the substrate W is nitrided under the foregoing condition in which the rate of concentration variation of the nitrogen radicals on the substrate W becomes minimum, wherein FIG.44A shows the thickness distribution obtained by ellipsometry, while FIG.44B shows the thickness distribution profile of the oxynitride film thus obtained and the distribution profile of the nitrogen concentration. In FIG.44B, it should be noted that the distribution of the nitrogen concentration is the one obtained by XPS analysis.

Referring to FIG.44A, the thickness distribution of the oxynitride film corresponds to the distribution of FIG.42A and it can be seen from the thickness distribution profile and the nitrogen concentration profile of FIG.44B, there is formed an oxynitride film of uniform composition on the substrate.

Thus, according to the substrate processing apparatus of the present example, it becomes possible to form a uniform oxynitride film on the surface of the substrate held in the processing vessel in the rotating stated, by forming a nitrogen radical flow in the processing vessel so as to flow along the surface of the substrate and by optimizing the velocity of the nitrogen radical flow.

Further, it should be noted that the substrate processing apparatus 110 of the present embodiment can also conduct oxygen plasma processing by supplying oxygen to the plasma radical source 93.

[TENTH EXAMPLE HELPFUL FOR UNDERSTANDING THE PRESENT INVENTION]

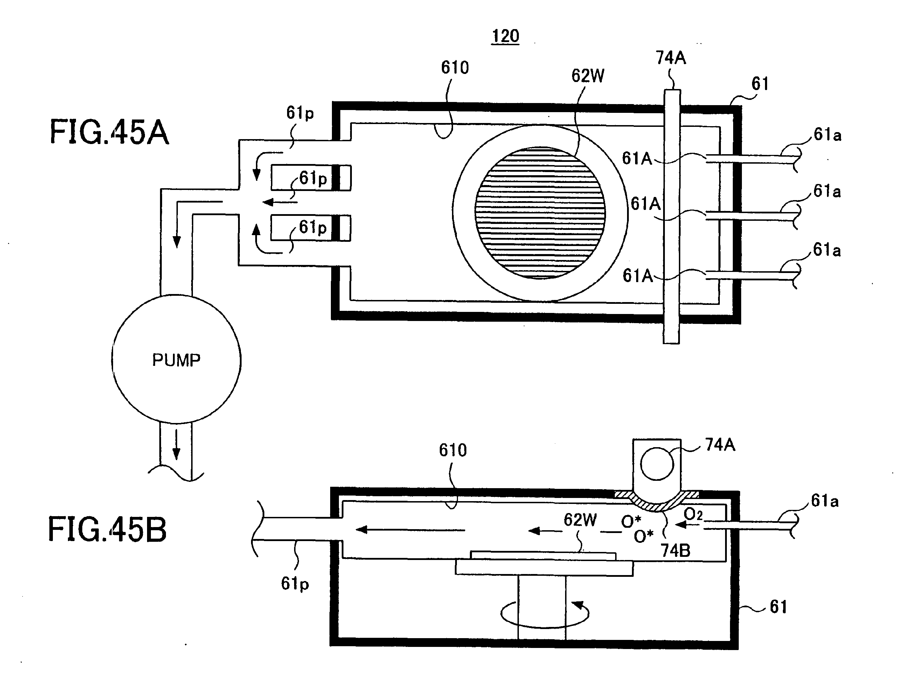

FIGS.45A and 45B show the construction of a substrate processing apparatus 120 according to tenth example helpful for understanding the present invention respectively in a plan view and in a cross-sectional view, wherein those parts corresponding to the parts explained previously are designated by the same reference numerals and the description thereof will be omitted.

Referring to FIGS.45A and 45B, the reaction vessel 61 is evacuated at a first end thereof via an evacuation port 61p connected to a pump 61P, and an oxygen gas in a line 61 a is supplied to the other end via a nozzle 61A. Further, there is provided an optical window 74B on the processing vessel 61 at a side offset to the end where the nozzle 61 A is provided with respect to the substrate 62W, and a linear ultraviolet source 74A is provided in correspondence to the optical window 74B.

In the substrate processing apparatus 120 of FIG.45A and 45B, it should be noted that there is provided an internal reactor 610 as the passage of the process gas, and the oxygen gas introduced from the nozzle 61 A is caused to flow through the inner reactor 610 to the evacuation port 61p along the surface of the substrate W exposed at the bottom part of the internal reactor 610, wherein the oxygen gas thus introduced is activated as it passes through the region right underneath the optical window 74B by the ultraviolet source 74A, and oxygen radicals O* are formed as a result. Thereby, it becomes possible to form a uniform oxide film on the surface of the substrate 62W by rotating the substrate 62W similarly to the previous example and by optimizing the velocity of the oxygen gas at the nozzle 61A.

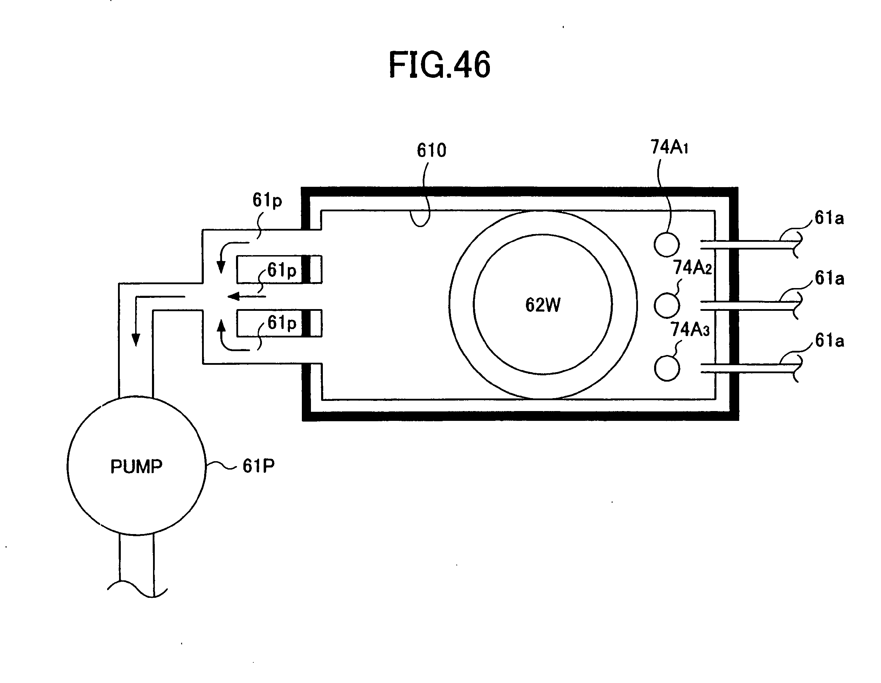

FIG.46 shows a modification in which the ultraviolet source 74A in the substrate processing apparatus 120 of FIG.45 is replaced with a plurality of ultraviolet sources $74A_1$ - $74A_3$.

In the present example, too, it becomes possible to form a uniform oxide film on the surface of the substrate 62W by optimizing the velocity of the oxygen gas at the nozzle 61A.

[ELEVENTH EXAMPLE HELPFUL FOR UNDERSTANDING THE PRESENT INVENTION]

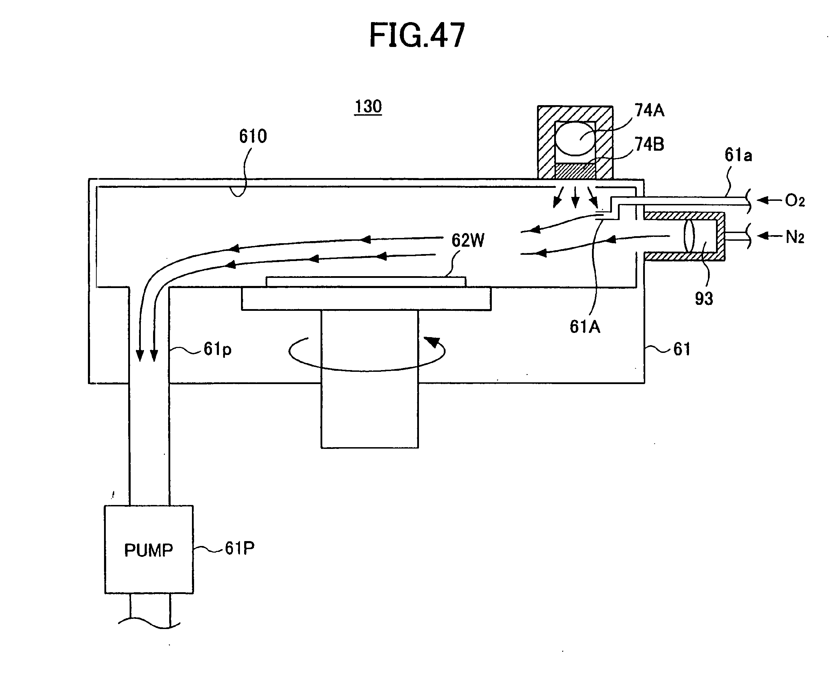

FIG.47 shows the construction of a substrate processing apparatus 130 according to an eleventh embodiment of the present invention, wherein those parts of FIG.47 corresponding to the parts described previously are designated by the same reference numerals and the description thereof will be omitted.

Referring to FIG.47, it can be seen that the evacuation port 61p connected to the pump 61P is provided at the first end of the processing vessel 61 and the nozzle 61A connected to the oxygen gas supply line 61a is provided at the second, opposite end. Further, the plasma source 93 supplied with a nitrogen gas and an inert gas and forming nitrogen plasma is provided at the second end.

The substrate 62 is exposed at the bottom part of the inner reactor 610 provided inside the processing vessel 61, and the oxygen gas supplied from the nozzle 61 A or the nitrogen radicals or oxygen radicals supplied from the plasma source 93 are caused to flow through the inner reactor 610 along the surface of the substrate 62W from the first end to the second end and discharged from the evacuation port 61p. Further, it can be seen that the ultraviolet source 74A is provided on the processing vessel 61 at the side closer to the second end with respect to the substrate 62W, and thus, it becomes possible to excite oxygen radicals in the oxygen gas flow by irradiating the ultraviolet radiation formed by the ultraviolet source 74A through the optical window 74B.

Thus, the substrate processing apparatus 130 of FIG.47 is capable of conducting the nitridation processing and oxidation processing of the substrate 62W flexibly according to the needs, and thus, it becomes possible to unify the processing chamber 43 and the processing chamber 44A in the event the substrate processing apparatus 130 is applied to the cluster-type semiconductor fabrication apparatus explained with reference to FIG.12.

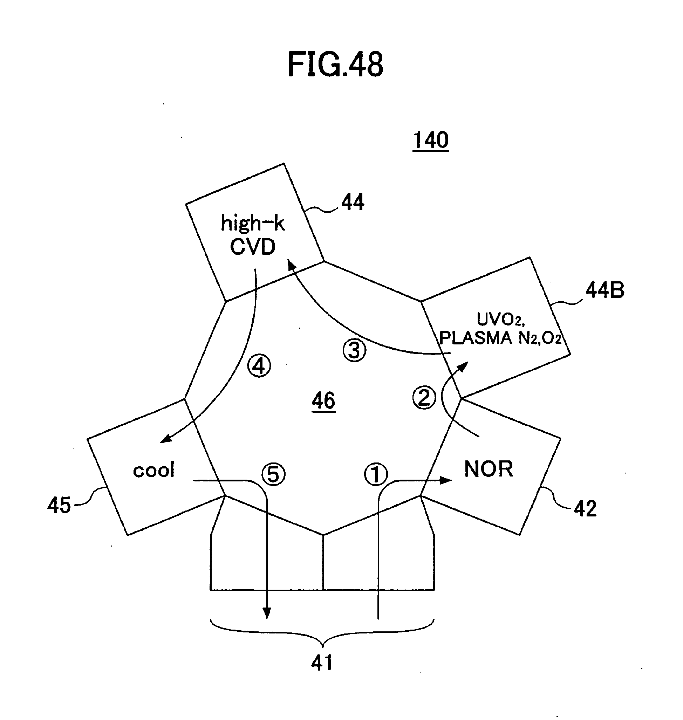

FIG.48 shows the construction of a cluster-type substrate processing system 140 in which the CVD processing chamber 44 for forming the high-K dielectric film of FIG.11 is combined with a processing chamber 44B in which the processing chamber 43 and the processing chamber 44A are unified. In FIG.48, it should be noted that those parts corresponding to the parts explained previously are designated by the same reference numerals and the description thereof will be omitted.

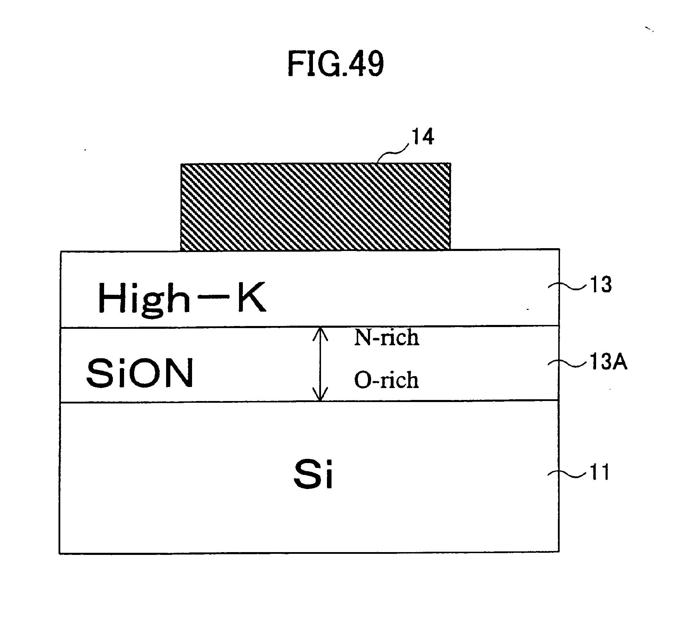

Referring to FIG.48, it is possible to conduct the ultraviolet-activated radical oxidation processing, plasma-activated radical oxidation processing, plasma-activated radical nitridation processing or a radical oxynitridation processing that combines any of these in the processing chamber 44B according to the needs, and thus, it becomes possible to fabricate a semiconductor device having a gate insulation film of laminated structure as shown in FIG.49 in which the SiON film 13A having a compositional gradient similarly to the case of FIG. 13 and the high-K dielectric film 13 explained with reference to FIG.1 are laminated and in which the gate electrode 14 is formed on such a gate insulation film.

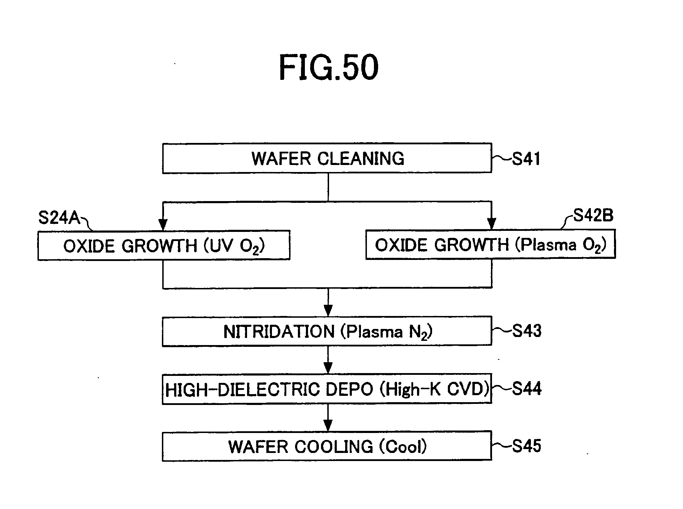

FIG.50 is a flowchart showing the process flow of fabricating a semiconductor device of FIG.49 by using the cluster-type substrate processing system 140 of FIG.48.

Referring to FIG.50, the Si substrate 11 is cleaned in the preprocessing chamber 42 in the first step 41 and native oxide film is removed from the substrate surface. The Si substrate 11 thus removed the native oxide film is then forwarded to the substrate processing apparatus 130 in the processing chamber 44B as the substrate 62W.

In the processing chamber 44B, the process proceeds to the step 42A or step 42B, wherein an oxygen gas is introduced into the inner reactor 610 of the substrate processing apparatus 130 from the line 61 a in the event the process has proceeded to the step 42A, and the ultraviolet source 74A is activated. Thereby, the oxygen radicals formed as a result of ultraviolet-activation of the oxygen gas form an oxide film on the surface of the Si substrate 11.

In the case the process has proceeded to the step 42B, on the other hand, the plasma source 93 is activated in the processing 44B, oxygen radicals are formed by supplying an oxygen gas to the plasma source 93 or by supplying an oxygen gas and an inert gas such as Ar to the foregoing plasma source 93. Thereby, the oxygen radicals form an oxide film on the surface of the Si substrate 11.

Next, the process proceeds to the step 43 and a nitrogen gas is introduced into the plasma source 93 in place of the oxygen gas, and as a result, there are formed nitrogen radicals in the reactor 610. As a result of formation of such nitrogen radicals, nitrogen is introduced to the surface of the oxide film, and the oxide film is converted to the oxynitride film 13A shown in FIG.13A.

Next, the substrate 11 is forwarded to the CVD chamber 44 for formation of the high-K dielectric gate insulation film 13 on the oxynitride film 13A, and thus, there is formed a high-K dielectric gate insulation film on the Si substrate 11.

Further, after a cooling process in the step 45, the substrate 11 is forwarded to an annealing step of the high-K dielectric gate insulation film and further to the process for formation of the gate electrode.

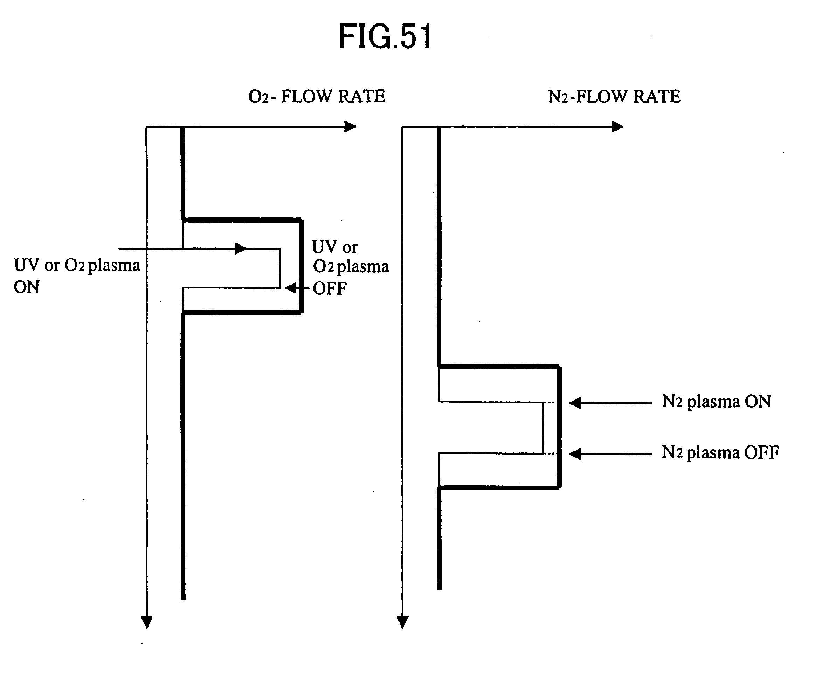

FIG.51 is a diagram showing the timing of supplying the oxygen gas and the nitrogen gas to the substrate processing apparatus 130 in the formation step of the oxynitride film corresponding to the step 42A or 42B or the step 43 of FIG.50, in superposition with the drive timing of the ultraviolet source 74A or the plasma source 93.

Referring to FIG.51, an oxygen gas is introduced into the inner reactor 610 of the substrate processing apparatus 130 in correspondence to the oxide film formation step 42A or 42B, and the ultraviolet source 74A or the plasma source 93 is activated. Further, by deactivating the ultraviolet source 74A or the plasma source 93, the formation of the oxide film is terminated. Thereafter, supply of the oxygen gas is terminated.

After the termination of the step for forming the oxide film in the step 42A or step 42B, a nitrogen gas is introduced into the inner reactor 610 in correspondence to the step 43, and the plasma source 93 is activated further. Further, by deactivating the plasma source 93, the nitridation process of the oxide film is terminated. Thereafter, the supply of the nitrogen gas is terminated. Here, it should be noted that simultaneous progress of the plasma nitridation process and plasma oxidation process is avoided by removing the residual oxygen in the substrate processing apparatus 130 by conducting vacuum evacuation process and nitrogen purging process repeatedly before starting the step 43. As a result, the problem of increase of the thickness of the underlying film in the step 43 is avoided.

Thus, by using the substrate processing apparatus 130 explained with reference to FIG.47, it becomes possible to conduct the foregoing radical oxidation processing and radical nitridation processing of the substrate in the same substrate processing in continuation, without exposing the substrate to the air in the present example. In the case of the cluster-type substrate processing system, it becomes possible to conduct the foregoing radical oxidation processing and the radical nitridation processing without returning the substrate to the transfer chamber 46. Thereby, the efficiency of substrate processing is improvised and the risk of contamination of the substrate is reduced. As a result, the yield of production of the semiconductor device is improved.

Further, the present invention is not limited to the specific embodiments explained heretofore, but various variations and modifications may be made within the scope of the invention as set forth in the claims.

## INDUSTRIAL APPLICABILITY

The present invention enables formation of an insulation film of uniform film quality in a substrate processing of apparatus using remote plasma by optimizing of the state of the remote plasma source.

Thus, according to the present invention, it becomes possible to form an extremely thin insulation film on a substrate surface with a uniform thickness. By forming a high-K dielectric gate insulation film, for example, on such an extremely thin and uniform insulation film, it becomes possible to realize a semiconductor device operating at high speed.

## Claims

**1.** A method of forming an insulation film on a substrate, **characterized by** the steps of:

supplying one and the same process gas to a plurality of radical sources (93; $93_1$, $93_2$) ;
forming active radicals from said process gas in each of said plurality of radical sources (93; $93_1$, $93_2$);
supplying said active radicals to a substrate surface (W); and
forming an insulation film by a reaction of said active radicals on said substrate surface (W);
said step of forming said active radicals being conducted while changing a state of each of said plurality of radical sources (93; $93_1$, $93_2$);
said method further comprising the steps of:

obtaining an optimum state in which a variation of film state within said insulation film becomes minimum for each of said plurality of radical sources (93; $93_1$, $93_2$) based on said state of said insulation film; and
forming an insulation film on said substrate surface (W) by setting each of said plurality of radical sources (93; $93_1$, $93_2$) to said optimum state,
said step of changing the state of said plurality of radical sources (93; $93_1$, $93_2$) comprises repeating the steps of:

changing a location (S21) of said plurality of radical sources (93; $93_1$, $93_2$) relatively with respect to said substrate (W), or changing an angle of said radical sources (93; $93_1$, $93_2$) with respect to said substrate (W);
forming an insulation film (S22) on the substrate (W) while using said plurality of radicals; and
evaluating uniformity (S23) of said insulation film formed on said substrate (W), until said optimum state is attained.

**2.** The method of forming an insulation film as claimed in claim 1 comprising changing the location of said plurality of radical sources until said optimum state is attained, further
comprising, after the optimization for the location of said plurality of radical Sources (93; $93_1$, $93_2$), the step of repeating the steps of:

changing a driving power (S32) of said radical sources (93; $93_1$, $93_2$);
forming an insulation film (S33) on the substrate (W) while using said plurality of radicals;
and
evaluating uniformity (S34) of said insulation film formed on said substrate (W) until an optimum state is attained.

**3.** The method of forming an insulation film as claimed in claim 1 or claim 2, wherein each of said plurality of radical sources (93; $93_1$, $93_2$) comprises a plasma source and an opening formed with a distance from said plasma source for passing said active radicals therethrough.

**4.** The method of forming an insulation film as claimed in any of claims 1-3, wherein said optimum state is chosen so as to minimize a film thickness variation of said insulation film for each of said plurality of radical sources (93; $93_1$, $93_2$).

**5.** The method of forming an insulation film as claimed in any of claims 1-3, wherein said optimum state is chosen so as to minimize a compositional variation of said insulation film for each of said plurality of radical sources (93; $93_1$, $93_2$).

**6.** A substrate processing apparatus for forming an insulation film on a substrate (W), **characterized by**:

a processing chamber (91) including a stage (92) for holding a substrate (W) wherein said stage (92) holding said substrate (W) is rotatable;
a plurality of radical sources (93; $93_1$, $93_2$) provided adjacent to said processing chamber (91) at respective locations, each of said radical sources (93; $93_1$, $93_2$) being supplied with one and the same process gas and supplying active radicals to said processing chamber (91); and
a radical source setup part setting up a state of said plurality of radical sources (93; $93_1$, $93_2$) such that said insulation film has a uniform film state, wherein said plurality of radical sources (93; $93_1$, $93_2$) are provided on respective locations at mutually different radial distances ($X_1$; $X_{23}$ in a radial direction of said substrate (W) held on said stage (92); and said radical source setup part is configured to repeat the steps of: changing a location (S21) of said plurality of radical sources (93; $93_1$, $93_2$) relatively with respect to said substrate (W),
or changing an angle of said radical sources (93; $93_1$, $93_2$) with respect to said substrate (W);
forming an insulation film (S22) on a substrate (W) while using said plurality of radicals; and
evaluating uniformity (S23) of said insulation film formed on said substrate (W), until said optimum state is attained.

**7.** The substrate processing apparatus as claimed in claim 6, comprising changing the location of said plurality of radical sources until said optimum state is attained and wherein said radical source setup part is further configured to repeat, after the optimization for the location of said plurality of radical sources (93; $93_1$, $93_2$), the steps of:

changing a driving power (S32) of said radical sources (93; $93_1$, $93_2$);
forming an insulation film (S33) on the substrate (W) while using said plurality of radicals; and
evaluating uniformity (S34) of said insulation film formed on said substrate (W) until an optimum state is attained.

**8.** The substrate processing apparatus as claimed in claim 6 or claim 7, wherein said radical source setup part holds each of said plurality of radical sources (93; $93_1$, $93_2$) movably with respect to said processing chamber (91).

**9.** The substrate processing apparatus as claimed in one of the claims 6 to 8, wherein said radical source setup part holds each of said plurality of radical sources (93; $93_1$, $93_2$) such that an angle with respect to said substrate (W) can be changed.

**10.** The substrate processing apparatus as claimed in one of claims 6 to 9, wherein said radical source setup part includes a drive circuit (95) driving said plasma sources (93; $93_1$, $93_2$).

**Patentansprüche**

**1.** Verfahren zum Ausbilden eines Isolierfilms auf einem Substrat, **gekennzeichnet durch** nachfolgende Schritte:

Bereitstellen ein und desselben Prozessgases an mehrere Radikalquellen (93; $93_1$, $93_2$);
Ausbilden aktiver Radikale aus dem Prozessgas in jeder der mehreren Radikalquellen (93; $93_1$, $93_2$);
Bereitstellen der aktiven Radikale an einer Substratoberfläche (W); und
Ausbilden eines Isolierfilms mittels einer Reaktion der aktiven Radikale auf der Substratoberfläche (W);
wobei der Schritt des Ausbildens der aktiven Radikale ausgeführt wird, während ein Zustand einer jeden der mehrere Radikalquellen (93; $93_1$, $93_2$) geändert wird;
wobei das Verfahren ferner die nachfolgenden Schritte umfasst:

Erreichen eines Optimalzustands, in welchen eine Variation des Filmzustands innerhalb des Isolierfilms für jede der mehreren Radikalquellen (93; $93_1$, $93_2$) auf der Grundlage des Zustandes des Isolierfilms ein Minimum annimmt; und
Ausbilden eines Isolierfilms auf der Substratoberfläche (W) **durch** Einstellen jeder der mehreren Radikalquellen (93; $93_1$, $93_2$) auf den Optimalzustand, wobei der Schritt des Änderns des Zustandes der mehreren Radikalquellen (93; $93_1$, $93_2$) das Wiederholen der nachfolgenden Schritte umfasst:

Ändern einer Position (S21) der mehreren Radikalquellen (93; $93_1$, $93_2$) bezüglich des Substrates (W) oder Ändern eines Winkels der Radikalquellen (93; $93_1$, $93_2$) bezüglich des Substrates (W);
Ausbilden eines Isolierfilms (S22) auf dem Substrat (W) während des Verwendens der mehreren Radikale; und
Auswerten einer Gleichförmigkeit (S23) des auf dem Substrat (W) ausgebildeten Isolierfilms, bis der Optimalzustand erreicht ist.

**2.** Verfahren zum Ausbilden eines Isolierfilms nach Anspruch 1, umfassend das Ändern der Position der mehreren Radikalquellen (93; $93_1$, $93_2$), bis der Optimalzustand erreicht ist, und ferner umfassend, nach der Optimierung der Position der mehreren Radikalquellen (93; $93_1$, $93_2$), den Schritt des Wiederholens der nachfolgenden Schritte:

Ändern einer Antriebsleistung (S32) der Radikalquellen (93; $93_1$, $93_2$);
Ausbilden eines Isolierfilms (S33) auf dem Substrat (W) während des Verwendens der mehreren Radikale; und
Auswerten einer Gleichförmigkeit (S34) des auf dem Substrat (W) ausgebildeten Isolierfilms, bis ein Optimalzustand erreicht ist.

**3.** Verfahren zum Ausbilden eines Isolierfilms nach Anspruch 1 oder 2, bei welchem jede der mehreren Radikalquellen (93; $93_1$, $93_2$) eine Plasmaquelle und eine Öffnung, welche zum Hindurchleiten der aktiven Radikale in einem Abstand von der Plasmaquelle ausgebildet ist, umfasst.

**4.** Verfahren zum Ausbilden eines Isolierfilms nach einem der Ansprüche 1 bis 3, bei welchem der Optimalzustand derart gewählt ist, dass eine Variation der Filmdicke des Isolierfilms für jede der mehreren Radikalquellen (93; $93_1$, $93_2$) minimiert wird.

**5.** Verfahren zum Ausbilden eines Isolierfilms nach einem der Ansprüche 1 bis 3, bei welchem der Optimalzustand derart gewählt ist, dass eine Variation der Zusammensetzung des Isolierfilms für jede der mehreren Radikalquellen (93; $93_1$, $93_2$) minimiert wird.

**6.** Substratbearbeitungseinrichtung zum Ausbilden eines Isolierfilms auf einem Substrat (W), **gekennzeichnet durch**:

eine Prozesskammer (91) mit einem Tisch (92) zum Aufnehmen eines Substrats (W),
wobei der das Substrat (W) aufnehmende Tisch (92) rotierbar ist;
mehrere Radikalquellen (93; $93_1$, $93_2$), welche benachbart zu der Prozesskammer (91) an entsprechenden Positionen bereitgestellt sind, wobei jede der Radikalquellen (93; $93_1$, $93_2$) mit ein und demselben Prozessgas versorgt wird und aktive Radikale an die Prozesskammer (91) bereitstellt; und
eine Radikalquelleneinrichtungseinheit, welche einen Zustand der mehreren Radikalquellen (93; $93_1$, $93_2$) derart einrichtet, dass der Isolierfilm einen gleichmäßigen Filmzustand aufweist, wobei die mehreren Radikalquellen (93; $93_1$, $93_2$) an entsprechenden Positionen bei voneinander unterschiedlichen Radialabständen ($X_1$; $X_2$) entlang einer Radialrichtung des auf dem Tisch (92) aufgenommenen Substrats (W) bereitgestellt sind; und
wobei die Radikalquelleneinrichtungseinheit zum Wiederholen der nachfolgenden Schritte eingerichtet ist: Ändern einer Position (S21) der mehreren Radikalquellen (93; $93_1$, $93_2$) bezüglich des Substrates (W) oder Ändern eines Winkels der Radikalquellen (93; $93_1$, $93_2$) bezüglich des Substrates (W); Ausbilden eines Isolierfilms (S22) auf einem Substrat (W) während des Verwendens der mehreren Radikale; und Auswerten einer Gleichförmigkeit (S23) des auf dem Substrat (W) ausgebildeten Isolierfilms, bis der Optimalzustand erreicht ist.

**7.** Substratbearbeitungseinrichtung nach Anspruch 6, welche zum Ändern der Position der mehreren Radikalquellen (93; $93_1$, $93_2$) bis zum Erreichen des Optimalzustands eingerichtet ist, wobei die Radikalquelleneinrichtungseinheit ferner dazu eingerichtet ist, nach der Optimierung der Position der mehreren Radikalquellen (93; $93_1$, $93_2$) die nachfolgenden Schritte zu wiederholen:

Ändern einer Antriebsleistung (S32) der Radikalquellen (93; $93_1$, $93_2$);
Ausbilden eines Isolierfilms (S33) auf dem Substrat (W) während des Verwendens der mehreren Radikale; und
Auswerten einer Gleichförmigkeit (S34) des auf dem Substrat (W) ausgebildeten Isolierfilms, bis ein Optimalzustand erreicht ist.

**8.** Substratbearbeitungseinrichtung nach Anspruch 6 oder 7, bei welcher die Radikalquelleneinrichtungseinheit jede der mehreren Radikalquellen (93; $93_1$, $93_2$) bezüglich der Prozesskammer (91) beweglich hält.

**9.** Substratbearbeitungseinrichtung nach einem der Ansprüche 6 bis 8, bei welcher die Radikalquelleneinrichtungseinheit jede der mehreren Radikalquellen (93; $93_1$, $93_2$) derart aufnimmt, dass ein Winkel bezüglich des Substrates (W) variiert werden kann.

**10.** Substratbearbeitungseinrichtung nach einem der Ansprüche 6 bis 9, bei welcher die Radikalquelleneinrichtungseinheit einen Antriebsschaltkreis (95) zum Antreiben der Plasmaquellen (93; $93_1$, $93_2$) umfasst.

## Revendications

**1.** Procédé pour former un film isolant sur un substrat, **caractérisé par** les étapes suivantes :

fournir un même gaz de traitement à une pluralité de sources de radicaux (93 ; $93_1$, $93_2$) ;
former des radicaux actifs à partir du gaz de traitement dans chacune de la pluralité de sources de radicaux (93 ; $93_1$, $93_2$) ;
fournir les radicaux actifs à une surface d'un substrat (W) ; et
former un film isolant par une réaction des radicaux actifs sur la surface du substrat (W) ;
ladite étape de formation des radicaux actifs étant effectuée sans changer l'état de chacune de la pluralité de sources de radicaux (93 ; $93_1$, $93_2$) ;
le procédé comprenant en outre les étapes suivantes :

obtenir un état optimum, dans lequel une variation de l'état du film dans le film isolant devient minimum, pour chacune de la pluralité de sources de radicaux (93 ; $93_1$, $93_2$), sur la base de l'état du film isolant ; et
former un film isolant sur la surface de substrat (W) en réglant chacune de la pluralité de sources de radicaux (93 ; $93_1$, $93_2$) à l'état optimum,

ladite étape de changement d'état de la pluralité de sources de radicaux (93 ; $93_1$, $93_2$) comprenant la répétition des étapes suivantes :

changer l'emplacement (S21) de la pluralité de sources de radicaux (93 ; $93_1$, $93_2$) par rapport au substrat (W), ou changer l'angle des sources de radicaux (93 ; $93_1$, $93_2$) par rapport au substrat (W) ;
former un film isolant (S22) sur le substrat (W) en utilisant la pluralité de radicaux ; et
évaluer l'uniformité (S23) du film isolant formé sur le substrat (W), jusqu'à ce que ledit état optimum soit atteint.

**2.** Procédé pour former un film isolant selon la revendication 1, comprenant un changement de l'emplacement de la pluralité de sources de radicaux jusqu'à ce que l'état optimum soit atteint, comprenant en outre, après l'optimisation de l'emplacement de la pluralité de sources de radicaux (93 ; $93_1$, $93_2$), l'étape consistant à répéter les étapes suivantes :

changer la puissance d'excitation (S32) des sources de radicaux (93 ; $93_1$, $93_2$) ;
former un film isolant (S33) sur le substrat (W) en utilisant la pluralité de radicaux ; et
évaluer l'uniformité (S34) du film isolant formé sur le substrat (W) jusqu'à ce qu'un état optimum soit atteint.

**3.** Procédé pour former un film isolant selon la revendication 1 ou 2, dans lequel chacune de la pluralité de sources de radicaux (93 ; $93_1$, $93_2$) comprend une source de plasma et une ouverture formée à une certaine distance de la source de plasma pour le passage des radicaux actifs.

**4.** Procédé pour former un film isolant selon l'une quelconque des revendications 1 à 3, dans lequel l'état optimum est choisi de façon à minimiser la variation de l'épaisseur du film isolant pour chacune de la pluralité de sources de radicaux (93 ; $93_1$, $93_2$) .

**5.** Procédé pour former un film isolant selon l'une quelconque des revendications 1 à 3, dans lequel l'état optimum est choisi de façon à minimiser la variation de composition du film isolant pour chacune de la pluralité de sources de radicaux (93 ; $93_1$, $93_2$) .

**6.** Dispositif de traitement de substrat pour former un film isolant sur un substrat (W), **caractérisé par** :

une chambre de traitement (91) comprenant un support (92) pour maintenir un substrat (W), dans laquelle le support (92) maintenant le substrat (W) est tournant ;
une pluralité de sources de radicaux (93 ; $93_1$, $93_2$) prévue à côté de la chambre de traitement (91) en des emplacements respectifs, chacune des sources de radicaux (93 ; $93_1$, $93_2$) étant alimentée par un même gaz de traitement et fournissant des radicaux actifs à la chambre de traitement (91) ; et
une partie de réglage de sources de radicaux réglant l'état de la pluralité de sources de radicaux (93 ; $93_1$, $93_2$) de telle sorte que le film isolant présente un état de film uniforme, la pluralité de sources de radicaux (93 ; $93_1$, $93_2$) étant prévue en des emplacements respectifs à des distances radiales mutuelles différentes ($X_1$ ; $X_2$) dans une direction radiale du substrat (W) maintenu sur le support (92) ; et
ladite partie de réglage de sources de radicaux est agencée pour répéter les étapes suivantes : changer l'emplacement (S21) de la pluralité de sources de radicaux (93 ; $93_1$, $93_2$) par rapport au substrat (W) ou changer l'angle des sources de radicaux (93 ; $93_1$, $93_2$) par rapport au substrat (W) ; former un film isolant (S22) sur le substrat (W) en utilisant la pluralité de radicaux ; et évaluer l'uniformité (S23) du film isolant formé sur le substrat (W), jusqu'à ce que l'état optimum soit atteint.

**7.** Dispositif de traitement de substrat selon la revendication 6, comprenant un changement de l'emplacement de la pluralité de sources de radicaux jusqu'à ce que l'état optimum soit atteint et dans lequel la partie de réglage de sources de radicaux est en outre agencée pour répéter, après l'optimisation de l'emplacement de la pluralité de sources de radicaux (93 ; $93_1$, $93_2$), les étapes suivantes :

changer la puissance d'excitation (S32) des sources de radicaux (93 ; $93_1$, $93_2$) ;

former un film isolant (S33) sur le substrat (W) en utilisant la pluralité de radicaux ; et
évaluer l'uniformité (S34) du film isolant formé sur le substrat (W) jusqu'à ce qu'un état optimum soit atteint.

**8.** Dispositif de traitement de substrat selon la revendication 6 ou 7, dans lequel la partie de réglage de source de radicaux maintient chacune de la pluralité de sources de radicaux (93 ; $93_1$, $93_2$) mobile par rapport à la chambre de traitement (91).

**9.** Dispositif de traitement de substrat selon l'une des revendications 6 à 8, dans lequel la partie de réglage de source de radicaux maintient chacune de la pluralité de sources de radicaux (93 ; $93_1$, $93_2$) de telle sorte que l'angle par rapport au substrat (W) peut être changé.

**10.** Dispositif de traitement de substrat selon l'une des revendications 6 à 9, dans lequel la partie de réglage de source de radicaux comprend un circuit d'excitation (95) excitant les sources de plasma (93 ; $93_1$, $93_2$).

FIG. 1

10
14
13
12
Si
11

FIG. 2

20
UV
23
21C
21B
$O_2$
21
22
21a
21A

FIG. 3
30
34
N2
34D
34E
34c
34b
34A
34B
34C
34F
34E
35
CONTROLLER
31
31C
31A
31B
32
31a
31D
33
O2

NO UV EXPOSURE
FIG. 4A
3.09
2.62
3.37 2.75 2.43 2.60 2.83
2.65
2.95
UV EXPOSURE
FIG. 4B
8.24
9.11
8.10 8.17 7.99 8.10 8.15
8.15
8.43
TOTAL SCAN
(410mm)
UNIFORMITY
2.72%
UV EXPOSURE
FIG. 4C
9.49
9.34
9.21 9.37 9.30 9.36 9.23
9.34
9.38
PARTIAL SCAN
(100mm)
UNIFORMITY
1.35%

FIG. 5

12
11
10
9
8
7
6
5
4
0
1
2
3
4
5
6
Thickness[A]
Time[min]
◆O2=5slm
■O2=2.5slm
△O2=1slm

FIG. 6A

|  |  | 11.49 |  |  |
|---|---|---|---|---|
|  |  | 11.64 |  |  |
| 10.92 | 11.61 | 11.78 | 11.77 | 11.11 |
|  |  | 11.59 |  |  |
|  |  | 11.45 |  |  |
|  |  |  | 3.73% |  |

Δ y = 0.0mm

FIG. 6B

|  |  | 9.54 |  |  |
|---|---|---|---|---|
|  |  | 9.81 |  |  |
| 9.39 | 9.89 | 9.92 | 9.99 | 9.52 |
|  |  | 9.88 |  |  |
|  |  | 9.70 |  |  |
|  |  |  | 3.07% |  |

Δ y = 12.5mm

FIG. 6C

|  |  | 9.73 |  |  |
|---|---|---|---|---|
|  |  | 9.81 |  |  |
| 9.36 | 9.85 | 9.90 | 9.95 | 9.47 |
|  |  | 9.82 |  |  |
|  |  | 9.64 |  |  |
|  |  |  | 3.07% |  |

Δ y = 25.0mm

FIG. 6D

|  |  | 9.77 |  |  |
|---|---|---|---|---|
|  |  | 9.81 |  |  |
| 9.35 | 9.74 | 9.76 | 9.78 | 9.29 |
|  |  | 9.73 |  |  |
|  |  | 9.56 |  |  |
|  |  |  | 2.70% |  |

Δ y = 37.5mm

FIG. 6E

|  |  | 10.41 |  |  |
|---|---|---|---|---|
|  |  | 10.47 |  |  |
| 9.57 | 10.27 | 10.26 | 10.24 | 9.45 |
|  |  | 9.97 |  |  |
|  |  | 9.54 |  |  |
|  |  |  | 5.08% |  |

Δ y = 50.0mm

FIG. 7A

| | | | | |
|---|---|---|---|---|
| | | 6.81 | | |
| | | 6.75 | | |
| 6.70 | 6.72 | 6.78 | 6.82 | 6.83 |
| | | 6.72 | | |
| | | 6.84 | | |
| | | | 1.08% | |

FIG. 7B

| | | | | |
|---|---|---|---|---|
| | | 7.87 | | |
| | | 7.96 | | |
| 7.86 | 7.91 | 8.04 | 8.03 | 8.07 |
| | | 7.93 | | |
| | | 7.87 | | |
| | | | 1.30% | |

FIG. 7C

| | | | | |
|---|---|---|---|---|
| | | 8.51 | | |
| | | 8.63 | | |
| 8.54 | 8.66 | 8.66 | 8.67 | 8.49 |
| | | 8.60 | | |
| | | 8.48 | | |
| | | | 1.11% | |

FIG. 7D

| | | | | |
|---|---|---|---|---|
| | | 8.92 | | |
| | | 9.01 | | |
| 8.92 | 9.04 | 9.06 | 9.08 | 9.94 |
| | | 9.05 | | |
| | | 8.86 | | |
| | | | 1.21% | |

FIG. 7E

| | | | | |
|---|---|---|---|---|
| | | 10.21 | | |
| | | 10.41 | | |
| 9.85 | 10.42 | 10.40 | 10.54 | 10.1 |
| | | 10.34 | | |
| | | 9.61 | | |
| | | | 4.57% | |

FIG. 8A

| | | | | | |
|---|---|---|---|---|---|
| | | 5. 10 | | | NO UV |
| | | 4. 75 | | | |
| 4. 95 | 4. 79 | 4. 72 | 4. 79 | 4. 99 | |
| | | 4. 86 | | | |
| | | 5. 11 | | | |
| | | | 4. 03% | | |

FIG. 8B

| | | | | | |
|---|---|---|---|---|---|
| | | 8. 81 | | | RTO |
| | | 8. 63 | | | |
| 8. 06 | 8. 50 | 8. 46 | 8. 43 | 8. 04 | |
| | | 8. 43 | | | |
| | | 8. 15 | | | |
| | | | 4. 57% | | |

FIG.9

START
REGION SELECT
S1
FILM GROWTH
S2
EVALUATION
S3
DETERMINE BEST SCAN REGION
S4
END

# FIG.10

START
SELECT BEST SCAN REGION
S11
SELECT DRIVE ENERGY
S12
FILM GROWTH
S13
EVALUATION
S14
DETERMINE PROGRAM
S15
END

FIG. 11

40
high-k
CVD
44
UV
$O_2$
43
③
④
46
②
cool
NOR
45
⑤
①
42
41

FIG. 12

40A
plasma
$N_2$
44A
UV
$O_2$
43
③
④
46
②
cool
⑤
①
NOR
45
42
41

FIG. 13

10A
14
SiON
N-rich
O-rich
13A
11
Si

FIG. 14

32
34B

34B′
32

FIG. 15A

FIG. 15B

FIG. 16

30'
34
$N_2$
33A
$O_2$
31C
34E
34D
34c
34A
31B'
31A
34b
34B
32
31a
34C
31D
34F
35
33
CONTROLLER

FIG. 17

SELF-LIMITING AREA
XPS Thickness [A]
8
7.8
7.6
7.4
7.2
7
6.8
6.6
6.4
10
20
30
40
UV power [%]

FIG. 18A

Pwr 15%

| | | | | |
|---|---|---|---|---|
| | | 7.45 | | |
| | | 7.42 | | |
| 7.29 | 7.38 | 7.37 | 7.43 | 7.29 |
| | | 7.36 | | |
| | | 7.31 | | |
| | | − | 1.10% | |

FIG. 18B

Pwr 20%

| | | | | |
|---|---|---|---|---|
| | | 7.83 | | |
| | | 7.88 | | |
| 7.64 | 7.89 | 7.86 | 7.9 | 7.79 |
| | | 7.81 | | |
| | | 7.78 | | |
| | | − | 1.70% | |

FIG. 18C

Pwr 25%

| | | | | |
|---|---|---|---|---|
| | | 7.7 | | |
| | | 8.18 | | |
| 8.16 | 8.16 | 8.15 | 8.2 | 8.14 |
| | | 8.14 | | |
| | | 8.14 | | |
| | | − | 3.03% | |

FIG. 18D

Pwr 30%

| | | | | |
|---|---|---|---|---|
| | | 8.38 | | |
| | | 8.52 | | |
| 8.42 | 8.43 | 8.42 | 8.48 | 8.3 |
| | | 8.42 | | |
| | | 8.43 | | |
| | | − | 1.31% | |

FIG. 18E

Pwr 35%

| | | | | |
|---|---|---|---|---|
| | | 8.46 | | |
| | | 8.6 | | |
| 8.41 | 8.46 | 8.57 | 8.6 | 8.43 |
| | | 8.5 | | |
| | | 8.62 | | |
| | | − | 1.21% | |

FIG. 18F

Pwr 40%

| | | | | |
|---|---|---|---|---|
| | | 9.12 | | |
| | | 9.23 | | |
| 9.02 | 9.22 | 9.28 | 9.34 | 9.11 |
| | | 9.29 | | |
| | | 9.09 | | |
| | | − | 1.74% | |

FIG. 19

4th layer
3rd layer
2nd layer
1st layer
silicom atom
oxygem atom

FIG.20A

FIG.20B

1.10
1.00
0.90
0.80
0.70
0.60
0.50
INTENSITY [a.u.]
-200 -150 -100 -50 0 50 100 150 200
POSITION [mm]
300mm
32
330mm
UV SOURCE 34B
30'
POWER CONTROL
35

FIG.21A
INTENSITY [a.u.]
1.10
1.00
0.90
0.80
0.70
0.60
0.50
-200 -150 -100 -50 0 50 100 150 200
POSITION [mm]
FIG.21B
32
34B1
34B2
34B3
110mm
POWER RATIO
1.55
1.00
1.55
50
POWER CONTROL
POWER CONTROL
POWER CONTROL
351
352
353

FIG. 22
60
WATER IN
64W
O2
61a
61
62
300mm φ WAFER
62W
64A
110mm
62A
62B
63
62C
62h
62H
61A
65
64
64W
WATER OUT
100mm
61P
PUMP

FIG. 23

Radical Source Position
from the Center of Wafar
0.75
0.7
0.65
0.6
0.55
0.5
0.45
0.4
0.35
0.3
INTENSITY [a. u.]
0
50
100
150
200
RADIAL DISTANCE [mm]
0mm
25mm
50mm
75mm
100mm
110mm
125mm
150mm
175mm

FIG. 24
70
POWER CONTROL
74a2
POWER CONTROL
74a1
WATER IN
64W
O2
61a
61
WAFER
62W
62
63
62B
74
74A1
25mm
74B
175mm
74A2
62C
62H
62h
61A
74B
64W
WATER OUT
100mm
61P
PUMP

FIG. 25

0.7
0.65
0.6
0.55
0.5
0.45
0.4
0.35
0.3
UV INTENSITY [a. u. ]
0
50
100
150
200
RADIAL DISTANCE [mm]
25mm
175mm
BOTH

80
POWER CONTROL
$74a_1$
$74A_1$
84
74B
$74A_2$
POWER CONTROL
$74a_2$
64W
WATER IN
64W
WATER OUT
$O_2$
61a
61
62W 300mm φ
WAFER
62
63
62B
62C
62h
62H
61A
PUMP
61P
50mm
165mm
60mm
100mm

FIG. 26

FIG. 27

74A1
74A2
WD1
0
r1
WD2
r2
62W

FIG. 28

0.75
0.7
0.65
0.6
0.55
0.5
0.45
0.4
0.35
0.3
UV INTENSITY [a. u.]
0
50
100
150
200
RADIAL DISTANCE [mm]
50mm WD:100mm
165mm WD:60mm
BOTH

FIG. 29A

N2
90
93
91
91A
W
92
94

FIG. 29B

0.97mTorr
8.6mTorr1
8.6mTorr2
N CONCENTRATION %
POSITION mm
10
8
6
4
2
0
-100
-50
0
50
100

93
μW
$N_2$
93B
93b
93A
93D
91
93a
93a
93C
93D
N*

FIG. 30

FIG. 31A
100
91
W
92
94
91A
N2
N2
93₂
93₁
X1
X2
FIG. 31B
91
W
X1
X2
r
93₂
93₁

FIG. 32A

N CONCENTRATION %
10
9
8
7
6
5
4
3
2
1
0
0
50
100
150
RADIAL DISTANCE mm

FIG. 32B

N CONCENTRATION %
5
4.5
4
3.5
3
2.5
2
1.5
1
0.5
0
0
50
100
150
RADIAL DISTANCE mm

# FIG.33

START
SELECT REGION
S21
FILM GROWTH
S22
EVALUATION
S23
DETERMINE BEST REGION
S24
END

# FIG.34

93₁(93₂)
93B
93A
PLASMA
93D
93D
93F
93F
93E
93E
93C
91

# FIG.35

START
SELECT BEST REGION
S31
SELECT DRIVE ENERGY
S32
FILM GROWTH
S33
EVALUATION
S34
DETERMINE PROGRAM
S35
END

# FIG.36

95
95D
CONTROL
95C
95C
95B
93₁,93₂,
MATCHER
μW
GENERATOR
PLASMA
95E
95A
91
CHAMBER
TUNER
μW
POWER UNIT

100A
93A
93C
96B
96
96A
91
93A
93C
96B
96

FIG. 37A

FIG. 37B

FIG. 38

100B
91
W
X1
X2
r
933
932
931

FIG.39
110
93 RADICAL SOURE
N2,O2
93
93
N-DISTRIBUTION
91
94
W
TC
PROCESS
GAS FLOW
PUMP
91A

FIG.40
σ2
σ1
A
A'
B
B'
x
y
$Ncon. = Intensity \cdot \exp\left[-\left\{\frac{(x-x_0)^2}{\sigma_1^2}+\frac{y^2}{\sigma_2^2}\right\}\right]+Base_Int$

Ar; 2slm
=0.27[Pam3/s]
x
y
σ1
σ2
Ar; 3.2slm
=0.43[Pam3/s]

FIG. 41A

FIG. 41B

Ar; 2slm 1st
Unif.=2.4%
22.6
22.4
22.2
22
21.8
21.6
21.4
21.2
100 80 60 40 20 0 -20 -40 -60 -80 -100

FIG. 42A

Ar; 3.2slm
Unif.=5.87%
25
24.5
24
23.5
23
22.5
22
100 80 60 40 20 0 -20 -40 -60 -80 -100

FIG. 42B

FIG.43A

N2 Flow ;50sccm 1Torr 120s
σ1
σ2
1.8slm
σ1, mm
σ2, mm
Ar Flow, slm
0
1
2
3
4
5
0
100
200
300
400
500

FIG.43B

N2 Flow ;50sccm 1Torr 120s
Ar
1.8slm
σ2
Uniformity
Ar
2slm
Ar
3.2slm
MIN
σ2, mm
Uniformity, %
σ1, mm
0
100
200
300
400
500
0
50
100
150
200
250
300
0
10
20
30
40
50

N Concenteation, %
3.0
2.5
2.0
1.5
1.0
0.5
0.0
23.0
22.5
22.0
21.5
21.0
20.5
20.0
SiO2 Thickness, A
-100
-50
0
50
100
Position, mm
SiO2 Thickness
N Concentration
22.6
22.4
22.2
22
21.8
21.6
21.4
21.2
100
80
60
40
20
0
-20
-40
-60
-80
-100

FIG. 44A

FIG. 44B

120
61
61a
61a
61a
74A
61A
61A
61A
62W
610
61p
61p
61p
PUMP
FIG.45A
61a
61
74A
$O_2$
74B
O*
O*
62W
610
61p
FIG.45B

FIG.46
61a
61a
61a
$74A_1$
$74A_2$
$74A_3$
62W
610
61p
61p
61p
61P
PUMP

FIG.47
130
74A
74B
61a
$O_2$
$N_2$
93
61
61A
62W
610
61p
61P
PUMP

# FIG.48

140
high-k
CVD
44
44B
UVO2,
PLASMA N2,O2
③
④
46
②
cool
⑤
①
NOR
45
42
41

FIG.49

14
High−K
13
SiON
N-rich
O-rich
13A
Si
11

# FIG.50

WAFER CLEANING
S41
S24A
OXIDE GROWTH (UV $O_2$)
S42B
OXIDE GROWTH (Plasma $O_2$)
NITRIDATION (Plasma $N_2$)
S43
HIGH-DIELECTRIC DEPO (High-K CVD)
S44
WAFER COOLING (Cool)
S45

FIG.51

N2-FLOW RATE
N2 plasma ON
N2 plasma OFF
O2- FLOW RATE
UV or O2 plasma OFF
UV or O2 plasma ON

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6028393 A
- JP 11150111 A
- EP 0661385 A1


### Non-patent literature cited in the description


- **Zhang, J-Y et al.** *Appl. Phys. Lett.,* 17 November 1997, vol. 71 (20), 2964-2966